Europäisches Patentamt

European Patent Office

Office européen des brevets

(11) Publication number: **0 574 919 A2**

# EUROPEAN PATENT APPLICATION

(21) Application number: 93109708.3

(22) Date of filing: 17.06.93

(51) Int. Cl.5: **G06F 15/60**, G06F 11/26

(30) Priority: 18.06.92 JP 159844/92
28.09.92 JP 257796/92

(43) Date of publication of application:
**22.12.93 Bulletin 93/51**

(84) Designated Contracting States:
**DE FR GB**

(71) Applicant: **MATSUSHITA ELECTRONICS
CORPORATION**
**1006, Ohaza Kadoma
Kadoma-shi, Osaka 571(JP)**

(72) Inventor: **Maekawa, Hidetsugu**
**2-3-407, Wakita-cho, Kadoma-shi
Osaka 571(JP)**
Inventor: **Shimeki, Yasuharu**
**8-A10-209, Yamada-nishi 2-chome, Suita-shi
Osaka 565(JP)**
Inventor: **Kayashima, Kazuhiro**
**24-12-202 Hoshigaoka 1-chome, Hirakata-shi**
**Osaka 573(JP)**
Inventor: **Niwa, Hisao**
**6-28-203 Shimizu 5-chome, Asahi-ku,
Osaka-shi
Osaka 535(JP)**
Inventor: **Shin, Seiichi**
**8-16-14, Mizukino, Moriya-cho,
Kitasohma-gun,
Ibaragi-ken 302.-01(JP)**
Inventor: **Motohara, Akira**
**2-2-7-201, Kamikawara-douri, Nada-ku,
Kobe-shi
Hyogo-ken 657(JP)**
Inventor: **Hosokawa, Toshinori**
**1-4-5, Kisaichi-yamate, Katano-shi
Osaka 576(JP)**

(74) Representative: **Patentanwälte Grünecker,
Kinkeldey, Stockmair & Partner
Maximilianstrasse 58
D-80538 München (DE)**

(54) **State transition diagram generator and test pattern generator.**

(57) To traverse as many states as possible for large-size circuits, evaluation function is defined which is optimized as it assumes an increased difference in pseudo-primary output value (state) from the past hysteresis. States are searched so as to optimize this evaluation function. Thus, a state transition graph is created. An evaluated value-calculating portion calculates an evaluated value. An evaluated value partial differential coefficient-calculating portion calculates the partial differential coefficient of the evaluated value with respect to the input value. An input-setting portion estimates the direction of search for inputs from this value and searches for states. This state transition graph generator is coupled to the prior art RTP method to generate test patterns.

# Fig. 8

## BACKGROUND OF THE INVENTION

1.Field of the Invention

The present invention relates to a state transition graph generator for a synchronous sequential circuit and also to a test pattern generator using such a graph generator.

2.Related Art of the Invention

A known state transition graph generator is described, for example, in "Implicited State Enumeration of Finite State Machines using BDD's," Proc. ICCAD-90, pp. 130-133, Nov. 1990. In this technique, a logic circuit is expressed in terms of a tree structure called a binary decision graph (BDD) and applied to the generation of a state transition graph. The prior art state transition graph generator will hereafter be described in further detail with reference to drawings.

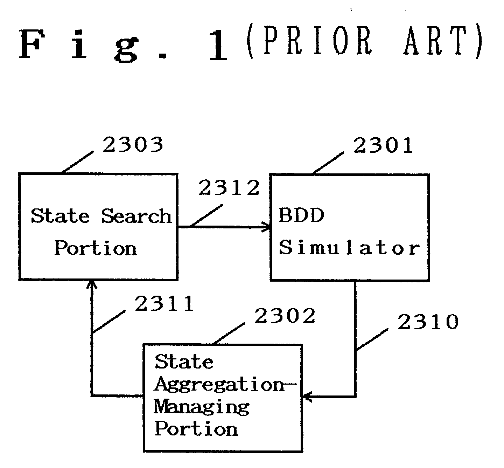

Fig.1 shows the structure of this known state transition graph generator. This generator comprises a binary decision graph (BDD) simulator 2301 which expresses a sequential circuit in terms of a BDD and finds an aggregate of states $x(t + 1)$ to which a transition can be made from a state $x(t)$ at time t as well as an input value necessary for the transition, the aggregate of the states appearing at the next time $(t + 1)$. A state aggregate-managing portion 2302 is a means for managing the aggregate of all states $\{x_i(t) | i = 1, ...,$ $N(t)\}$ (where $N(t)$ is the number of states reached at the time t) which are reached from the initial state up to the time t. A state search portion 2303 drives the BDD simulator, using the state aggregate in the state transition-managing portion 2302 at the time t. Signal lines 2310-2312 interconnect the various blocks.

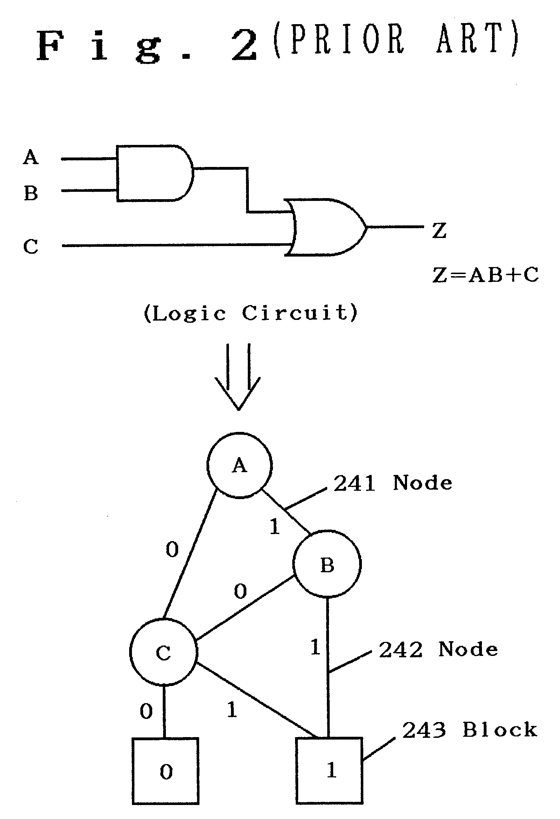

The operation of the prior art state transition graph generator constructed as described above will be described briefly . First, the BDD simulator 2310 expresses a logic circuit in terms of a BDD. Fig.2 shows an example in which a simple logic circuit is expressed in terms of a BDD. In this figure, a node 241 indicates that a signal line A takes logic 1. A node 242 indicates that a signal line B takes logic 1. A block 243 indicates that the logic value of a signal line Z takes logic 1. These nodes indicate that the signal Z takes logic 1, provided that both signal lines A and B take logic 1. In this way, the BDD gives a graphic representation of a true value table, and it is relatively easy to understand how input values are assigned to obtain a given output value.

Thereafter, the aggregate of states which can be reached from the initial state of the sequential circuit is searched. This searching operation is described below.

(step 1)

The state aggregate-managing portion 2302 establishes the initial state $x(0)$ of the sequential circuit and outputs the established state to the signal line 2311 (time $t = 0$).

Since the following processing takes the form of a loop, an expression "time t" is generally adopted (the first operation is performed at $t = 0$).

(step 2)

The state search portion 2303 selects one from an aggregate of all states $\{x_i(t) | i = 1, ..., N(t)\}$ reached at time t (where $N(t)$ is the number of states reached at time t) and outputs the selected ones to the signal line 2312. The BDD simulator 2301 finds the subsequent state (state appearing at the next time) which can be reached from that state, as well as input values leading to each state, and outputs these states to the signal line 2310. The state aggregate-managing portion 2302 stores input values corresponding to the aforementioned subsequent states output to the signal line 2310. The processing described above is repeated $N(t)$ times. The state aggregate-managing portion 2302 finds the aggregate of said subsequent states $\{x_i(t+1) | i = 1, ..., N(t+1)\}$ and outputs this aggregate to the signal line 2311.

(step 3)

If $N(t+1) = N(t)$, i.e., a transition to a new state is not discovered, then the search is terminated. If $N(t+1) > N(t)$, i.e., a transition to a new state is discovered, then the time is advanced to the next time, and control goes to step 2.

As described thus far, the prior art state transition graph generator expresses a logic circuit in terms of a BDD and thus finds the aggregate of states that can be reached from the initial state, as well as input values leading to these states.

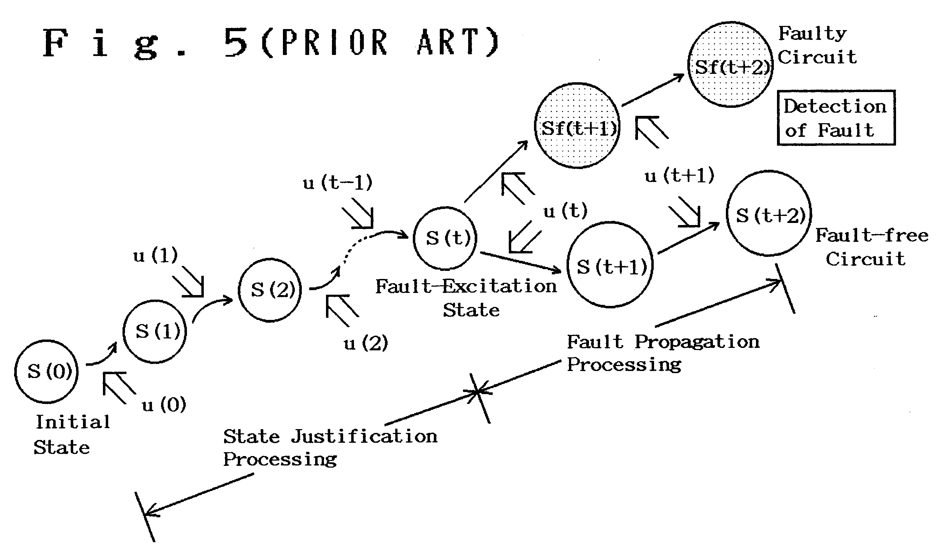

A known test pattern generator is described, for example, in "Sequential ATPG with Timing Consideration," Pro. of the Synthesis and Simulation Meet. and Int. Interchange, pp. 272-281, Apr. 1992. This apparatus automatically generates a test pattern used to inspect exported semiconductor devices using a procedure known as RTP (reverse time processing). Processing steps of this prior art test pattern generator are broadly classified into two categories: (1) state justification processing, and (2) fault propagation processing. These steps are conceptually illustrated in Fig. 5. State justification processing is intended to generate a test pattern (u(0), ..., u(t-1)) for making a transition from an initial state S(0) to a state S(t) (hereinafter referred to as the fault excitation state) in which a faulty circuit differs in operation from a fault-free circuit. Since the fault-free circuit and the faulty circuit are exactly identical in operation during processing of state justification, it is necessary to take account of only the fault-free circuit. Fault propagation processing is performed to generate a test pattern (u(t), u(t + 1)) so that the effect of a fault can be detected as a difference in primary output value of these two test patterns, i.e., u(0),u(1), ...,u(t-1),u(t), u-(t + 1). The prior art test pattern generator performs state justification processing and fault propagation processing by utilizing the RTP method. That is, items are searched in the order u(t + 1), u(t), u(t-1), and so forth.

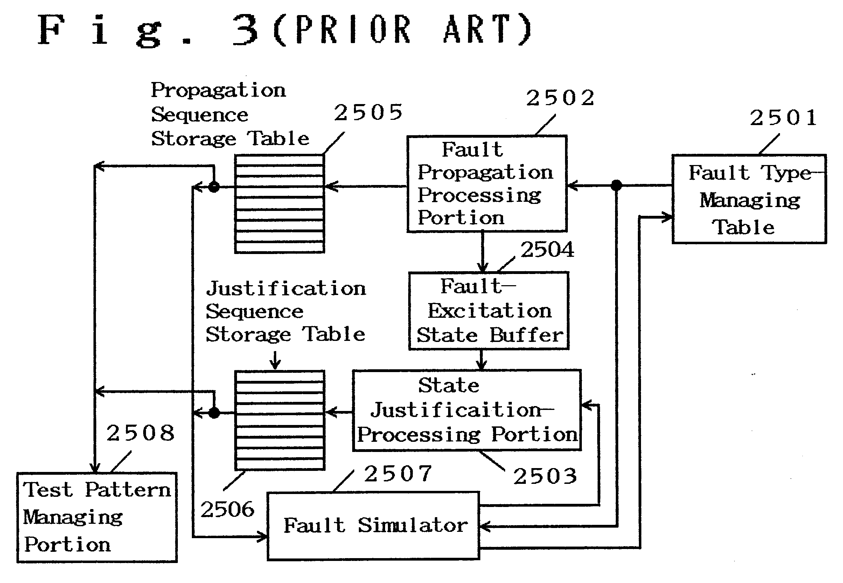

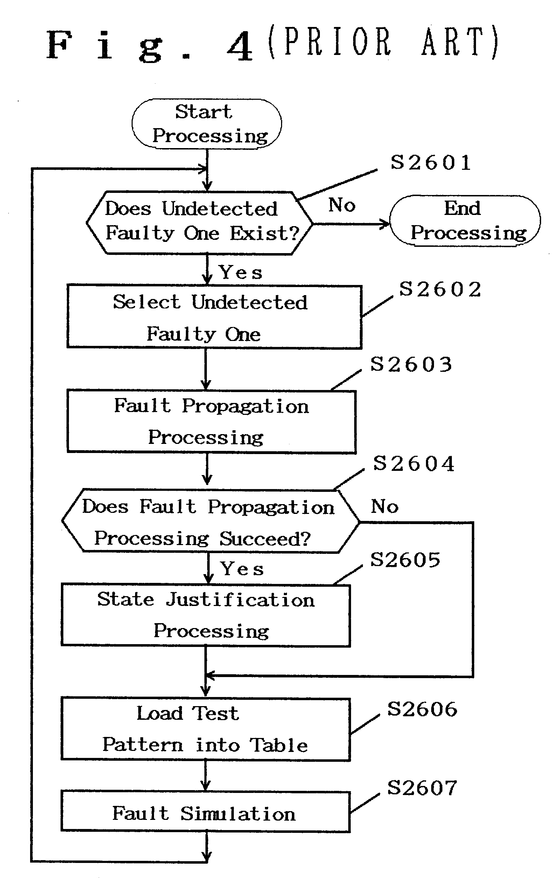

Fig. 3 shows the structure of the prior art test pattern generator. Fig. 4 is a flowchart illustrating the operation of the generator. In Fig. 3, a fault type-managing table 2501 manages the fault type in a sequential circuit for which a test pattern is to be generated. A fault propagation processing portion 2502 relies on the RTP method. Similarly, a state justification processing portion 2503 employs the RTP method. A fault excitation state buffer 2504 stores a fault excitation state. A propagation sequence storage table 2505 stores a test pattern generated by the fault propagation. A justification sequence storage table 2506 stores a test pattern generated by the state justification. 2507 is a fault simulator and a test pattern-managing portion 2508 is for storing the entire test pattern generated. The operation of the conventional test pattern generator constructed in this way is described next by referring to Figs. 3 and 4.

(step 2601)

The fault type-managing table 2501 determines whether there remains an unsearched fault type. If it is absent, the processing for generating a test pattern is ended.

(step 2602)

The fault type-managing table 2501 selects one fault type which is neither detected nor searched.

(step 2603)

The fault propagation processing portion 2502 performs fault propagation processing by the RTP method on the fault type selected in step 2602. The generated test pattern is stored in the propagation sequence storage table 2505.

(step 2604)

The fault propagation processing portion 2502 determines whether the fault propagation processing has been done successfully. If it is successful, the fault excitation state is output to the fault excitation state buffer 2504, and then control goes to step 2605. If the processing is unsuccessful, control skips to step 2606.

(step 2605)

The state justification processing portion 2503 fetches the fault excitation state from the fault excitation state buffer 2504 and searches for a test pattern to make a transition from the initial state to this fault excitation state by the RTP method. The initial state at this time is the state of the fault-free circuit after the fault simulator 2507 is driven in step 2607 (described later). The generated test pattern is stored in the justification sequence storage table 2506.

4

(step 2606)

A test pattern generated for the fault type selected in step 2602 is stored in the test pattern-managing portion 2508. In particular, test patterns stored in the propagation sequence storage table 2505 and in the justification sequence storage table 2506 are stored in the order of state justification sequence and fault propagation sequence.

(step 2607)

The fault simulator 2507 makes a simulation of a fault, using the test pattern generated for the fault type selected in step 2602. Information about the newly detected fault type is output to the fault type-managing table 2501. The state of the fault-free circuit after the fault simulator 2507 is driven is output to the state justification processing portion 2503. Finally, the propagation sequence storage table 2505 and the justification sequence storage table 2506 are cleared. Then, control returns to step 2601.

As described thus far, the prior art test pattern generator generates test patterns for all fault types by the RTP method.

However the above-described prior art state transition graph generator expresses a logic circuit in terms of a BDD and therefore has the following problems.

The number of nodes after conversion is affected greatly by the performance of the algorithm used to express a logic circuit in terms of a BDD. Even if an excellent transformation algorithm is employed, the number of nodes increases explosively as the size of the logic circuit increases and so the required storage capacity explodes. Consequently, for a logic circuit having 2000 or more gates, no practical state transition graph generator is available.

## SUMMARY OF THE INVENTION

In view of the foregoing problems with the prior art state transition graph generator, it is an object of the present invention to provide a state transition graph generator which needs less storage capacity and can be applied to a logic circuit having 2000 or more gates. In addition to this object, the amount of calculation needed to generate a state transition graph can be reduced by reducing the number of trial searches for inputs.

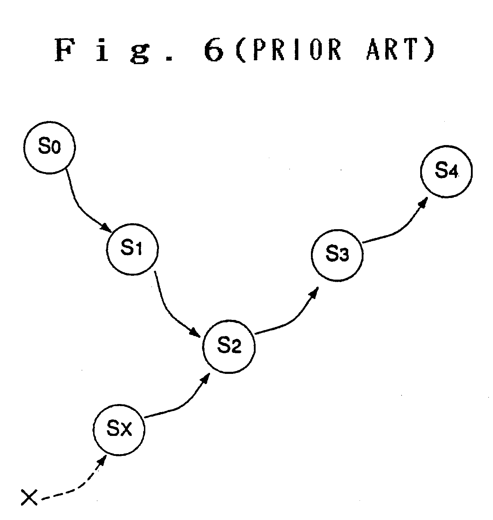

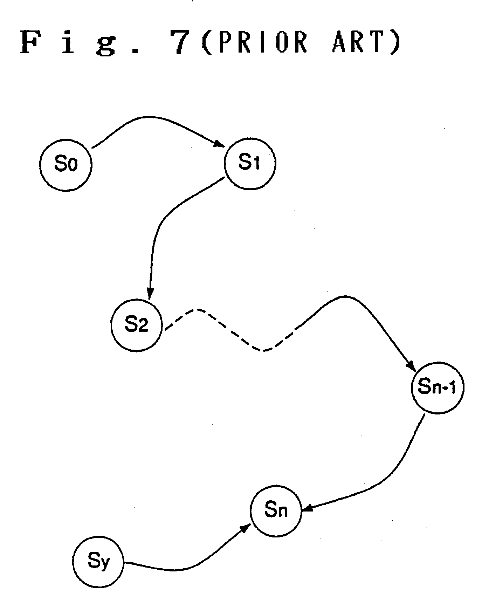

The above-described prior art test pattern generator may sometimes be unsuccessful in performing state justification processing. This hinders improvement in the fault coverage. Two typical cases in which the prior art test pattern generator fails in performing state justification processing are described below with reference to Figs. 6 and 7.

(1) where plural possible states to which a search should be traced back exist when time is retraced in the RTP method

In Fig. 6, it is assumed that $S_0$ indicates an initial state and that $S_4$ indicates a fault excitation state. In the prior art techniques, the state is justified from $S_4$ to $S_3$ backward in time. If a transition to $S_x$ is made without making a transition from $S_2$ to $S_1$, the state justification will fail.

(2) where a path going from an initial state to a fault excitation state is very complex

In Fig. 7, it is assumed that $S_0$ indicates an initial state and that $S_n$ indicates a fault excitation state. In the prior art techniques, the state is justified from $S_n$ to $S_{n-1}$ backwards in time. Since the path going to $S_0$ is too complex, the state justification fails.

In view of the problems with the foregoing prior art test pattern generator, it is an object of the present invention to provide an test pattern generator with high performance fault detection by improving the state justification ability.

A state transition graph generator of the present invention comprises:

an analog logical calculation means for causing logic elements included in a combinatorial circuit section in a sequential circuit having at least one flip-flop to take an analog form by the use of a nonlinear function and for calculating analog logical values of signal lines in the sequential circuit from an input value and from a state of the storage element;

an information amount-calculating means for performing calculations to store a pseudo-primary output value of the sequential circuit as a hysteresis in an inverse matrix of a covariance matrix, the pseudo-primary output value being delivered from said analog logical calculation means;

an evaluated value-calculating means for calculating an evaluated value which is changed toward its optimum value as a difference between the pseudo-primary output value output from said analog logical calculation means and the hysteresis of the pseudo-primary output value delivered from said information amount-calculating means increases;

a differentiated value-calculating means for calculating a Jacobian matrix of the pseudo-primary output value with respect to the input value;

an evaluated value partial differential coefficient-calculating means for calculating a partial differential coefficient of the evaluated value with respect to the input value from the Jacobian matrix delivered from said differentiated value-calculating means and from the pseudo-primary output value of the sequential circuit delivered from said analog logical calculation means; and

an input-setting means for estimating an input search direction which minimizes the evaluated value from the evaluated value partial differential coefficient delivered from said evaluated value partial differential coefficient-calculating means and for repeatedly searching for an input value that optimizes the evaluated value.

A first test pattern generator of the present invention comprises:

a fault propagation processing means for generating a test pattern (fault propagation sequence) until a fault-free circuit and a faulty circuit output different output values;

a fault type-managing means for managing all fault types;

a state-maintaining means for maintaining a fault excitation state delivered from said fault propagation-processing means;

a state transition graph-generating means for searching for a state that can be reached from an arbitrary initial state; and

a state transition-managing means for maintaining states searched by said state transition graph-generating means and test patterns leading to these states from an arbitrary initial state, extracting a fault excitation state from said state transition-holding means, determining whether this fault excitation state is present in the searched states, and generating a test pattern leading to this fault excitation state if it is present.

A second test pattern generator of the present invention comprises:

a state justification processing means for generating a test pattern until a fault-free circuit and a faulty circuit become different in operation due to a fault excitation state from an initial state;

a fault propagation processing means for generating a test pattern (fault propagation sequence) until a fault-free circuit and a faulty circuit output different output values;

a state-maintaining means for maintaining a fault excitation state generated by said fault propagation processing means and a target state which is generated by said state justification processing means and is undergoing state justification processing;

a state transition graph-generating means for searching for a state that can be reached from an arbitrary initial state; and

a state transition-managing means for maintaining states searched by said state transition graph-generating means and test patterns leading to these states from the arbitrary initial state, extracting a fault excitation state or a target state from said state-maintaining means, determining whether this fault excitation state is present in the searched states, and generating a test pattern leading to this fault excitation state if it is present.

A third test pattern generator of the present invention comprises:

a state justification processing means for generating a test pattern until a fault-free circuit and a faulty circuit become different in operation due to a fault excitation state from an initial state;

a fault propagation processing means for generating a test pattern (fault propagation sequence) until a fault-free circuit and a faulty circuit output different output values from a fault excitation state;

a fault type-managing means for managing all fault types;

a state-maintaining means for maintaining a fault excitation state generated by said fault propagation processing means;

a state transition graph-generating means for searching for a state that can be reached from an arbitrary initial state;

an undetected fault type-managing means for managing undetected fault types which can be detected neither by said state justification processing means nor by said fault propagation processing means; and

a state transition-managing means for maintaining states searched by said state transition graph-generating means and test patterns leading to these states from an arbitrary initial state, extracting a fault excitation state of an undetected fault type from said state-maintaining means, determining whether this fault excitation state is present in the searched states, and generating a test pattern leading to this fault excitation state if it is present.

Hereinafter the operation of the present invention is described.

The state transition graph generator of the present invention is constructed as described above. The analog logical calculation means calculates an analog logic value from possible input values delivered from the input-setting means. The evaluated value-calculating means calculates an evaluated value. The evaluated value partial differential coefficient-calculating means calculates the partial differential coefficients of the evaluated value with respect to the possible input values. The input-setting means estimates the direction of search for input values which optimizes the evaluated value from information about the partial differential coefficients of the evaluated value and outputs the next input possible values. The processing described thus far is repeated, and a state transition graph is created while searching for an input value which optimizes the evaluated value. As described above, the analog logical calculation means merely causes the logic elements in the sequential circuit to assume an analog form by means of a nonlinear function. Therefore, the storage capacity needed to expand the circuitry is much smaller than in the case of a BDD. Also, almost no memory is necessary because the evaluated value is based on a covariance matrix having a dimension which is at most comparable to the dimension of the number of bits in the flip-flops. Hence, a state transition graph generator which can be applied to a sequential circuit having 2000 or more gates can be obtained. Furthermore, the number of trial searches for inputs can be greatly reduced, because the input-setting means searches for a input value by making use of information about the partial differential coefficient of the evaluated value with respect to the input value.

The first test pattern generator according to the invention is constructed as described above. First, the state transition graph-generating means searches for states which can be reached from an arbitrary initial state. States reached by the fault-free circuit and the test patterns leading to these states are loaded into the state transition-managing means. Then, the fault type-managing means selects one from among unsearched and undetected fault types. The fault propagation processing means generates a fault propagation sequence and outputs a fault excitation state to the state-maintaining means. The state transition-managing means extracts the fault excitation state from the state-maintaining means and determines whether this state is present in the searched states. If it is present, a test pattern leading to this state is generated. Finally, these test patterns are connected to generate a test pattern for the selected fault type. Since the test pattern is created by making use of the state transition graph-generating means in this way, a test pattern generator capable of detecting faults at a high rate can be obtained.

The second test pattern generator according to the invention is constructed as described above. First, the state transition graph-generating means searches for a state which can be reached from an arbitrary initial state. A state reached by the fault-free circuit and the test pattern leading to this state are loaded into the state transition-managing means. Then, the fault type-managing means selects one out of unsearched and undetected fault types. The fault propagation processing means generates a fault propagation sequence and supplies a fault excitation state to the state-maintaining means. The state transition-managing means extracts the fault excitation state from the state-maintaining means and determines whether this state is present in the searched states. If it is present, a test pattern leading to this state is generated. If it is absent, the state justification processing means generates a test pattern at the immediately preceding time and outputs a target state at this preceding time in the state-maintaining means. The processing described thus far is repeated, using the target sequence stored in the state-maintaining means. Test patterns between the initial state and the fault excitation state are generated. Finally, these test patterns are connected, and a test pattern for the selected undetected fault type is generated. In this manner, the state transition graph-generating means and the state justification processing means are used complimentarily to generate the test pattern, and hence a test pattern generator capable of detecting faults at a high rate can be derived.

The third test pattern generator according to the invention is constructed as described above. First, test patterns are generated through the use of the state justification processing means and the fault propagation processing means. Then, the fault type-managing means outputs the undetected fault types to the undetected fault type-managing means. If undetected fault types exist, the state transition graph-generating means searches for a state which can be reached by the fault-free circuit from an arbitrary initial state. The reached states and test patterns leading to them are loaded into the state transition-managing means. Then, the undetected fault type-managing means selects one from among the unsearched fault types. The fault propagation processing means generates a fault propagation sequence and outputs a fault excitation state to the state-maintaining means. The state transition-managing means extracts the fault excitation state from the state-maintaining means and determining whether this state is contained in the searched states. If it is contained, a test pattern leading to this state is generated. Finally, these test patterns are connected to generate an additional test pattern for the selected undetected fault type. Since the additional test pattern for the undetected fault type is generated utilizing the state transition graph-generating means, in this way a test pattern generator capable of detecting faults at a high rate can be derived.

7

## BRIEF DESCRIPTION OF THE DRAWINGS

Fig.1 is a graph of a prior art state transition graph generator;

Fig.2 is a graph illustrating a method of expressing a logic circuit in terms of BDD in prior art techniques;

Fig. 3 is a graph of a prior art test pattern generator;

Fig. 4 is a flowchart illustrating the operation of the prior art test pattern generator;

Fig. 5 is a graph illustrating the manner in which the prior art test pattern generator generates test patterns;

Fig. 6 is a graph illustrating a case in which the prior art test pattern generator fails in state justification processing;

Fig. 7 is a graph illustrating another case in which the prior art test pattern generator fails in state justification processing;

Fig. 8 is a block graph of a state transition graph generator according to a first embodiment of the invention;

Fig. 9 is a flowchart illustrating the operation of the state transition graph generator shown in Fig. 8;

Fig. 10 is a flowchart illustrating the detailed operation of input search processing of the operation illustrated in Fig. 9;

Fig. 11 is a graph illustrating a method of searching states by the state transition graph generator shown in Fig. 8;

Fig. 12 is a block graph of a state transition graph generator according to a second embodiment of the invention;

Fig. 13 is a flowchart illustrating the operation of the state transition graph generator shown in Fig. 12;

Fig. 14 is a flowchart illustrating the detailed operation of base search processing of the operation illustrated in Fig. 13;

Fig. 15 is a flowchart illustrating the detailed operation of input search processing illustrated in Fig. 14;

Fig. 16 is a graph illustrating a method of searching states by means of a state transition graph generator of the second or a third embodiment of the invention;

Fig. 17 is a graph illustrating one example of input search processing performed by a state transition graph generator of the second or third embodiment of the invention;

Fig. 18 is a block graph of a state transition graph generator of the third embodiment of the invention;

Fig. 19 is a graph illustrating the concept of 2-bit division introduced in an evaluation function of a state transition graph generator of the third embodiment of the invention;

Fig. 20 is a graph of a test pattern generator of the first embodiment of the invention;

Fig. 21 is a flowchart illustrating the operation of a test pattern generator of the first or second embodiment of the invention;

Fig. 22 is a graph illustrating the manner in which a test pattern generator of the first or third embodiment of the invention generates test patterns where a state transition graph generator of the first embodiment of the invention is used to generate a state transition graph;

Fig. 23 is a graph illustrating the manner in which a test pattern generator of the first or third embodiment of the invention generates test patterns where a state transition graph generator of the second or third embodiment of the invention is used to generate a state transition graph;

Fig. 24 is a graph of a test pattern generator of the second embodiment of the invention;

Fig. 25 is a flowchart illustrating the detailed operation of the state justification processing of a test pattern generator of the second embodiment of the invention;

Fig. 26 is a graph illustrating the manner in which a test pattern generator of the second embodiment of the invention generates test patterns where a state transition graph generator of the first embodiment of the invention is used to generate a state transition graph;

Fig. 27 is a graph illustrating the manner in which a test pattern generator of the Second embodiment of the invention generates test patterns where a state transition graph generator of the second or third embodiment of the invention is used to generate a state transition graph;

Fig. 28 is a graph of a test pattern generator of the third embodiment of the invention; and

Fig. 29 is a flowchart illustrating the operation of a test pattern generator of the third embodiment of the invention.

## PREFERRED EMBODIMENTS OF THE INVENTION

A first embodiment of a state transition graph generator according to the invention is described next, with reference to the drawings. In the following description, it is assumed that a sequential circuit has p-bit

8

primary outputs, j-bit primary inputs, and i-bit flip-flops.

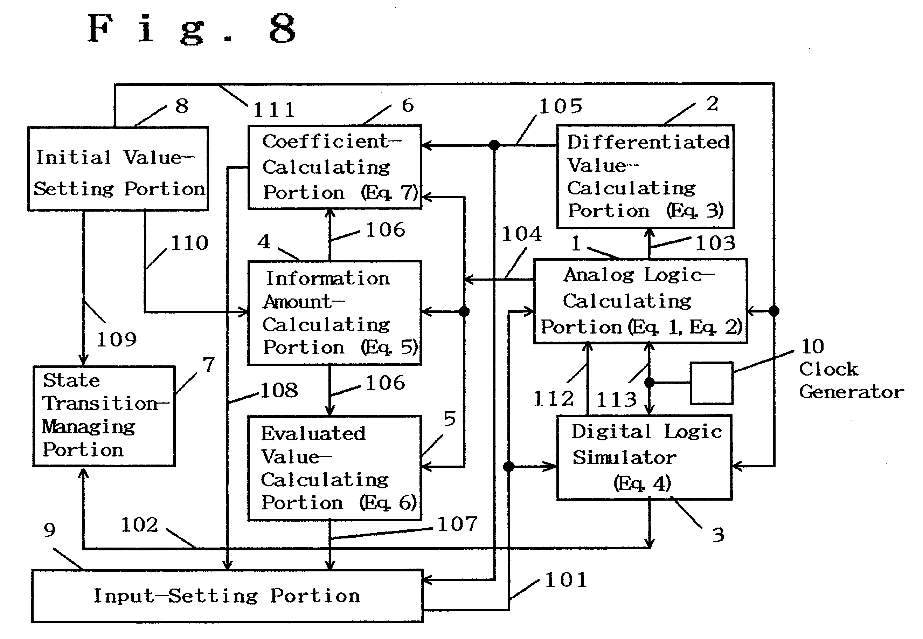

Fig. 8 shows the structure of the first embodiment of the state transition graph generator of the present invention. In Fig. 8, an analog logic calculator portion 1 transforms a synchronous sequential circuit into a nonlinear system and performs calculations given by Eq. 2. In the calculation processing of Eq. 2, every logic value of the signal lines in a combinatorial circuit incorporated in the sequential circuit can be obtained. First, each logic element is approximated by an analog logic defined by Eq. 1. The analog logic value defined herein takes a continuous value from -1 to 1. The minus sign indicates logic 0, while the plus sign indicates logic 1. A sigmoid or sigmoidal function is used in approximations made by analog logic. The use of this sigmoidal function has the advantage that the form of differentiation is simple.

```
n-input AND elements
```

$$\text{out}(x_1, x_2, .., x_n) = \text{sigmoid}(x_1 + x_2 + ... x_n - (n-1))$$

```
n-input OR elements
```

$$\text{out}(x_1, x_2, .., x_n) = \text{sigmoid}(x_1 + x_2 + ... x_n + (n-1))$$

```
NOT elements
```

$$\text{out}(x_1) = -x_1$$

```
nonlinear, uniformly increasing function sigmoid
```

$$\text{sigmoid}(x) = \frac{1-\exp(-c*x)}{1+\exp(-c*x)}$$

$$\text{where } c = 3.0$$

$$(\text{Eq. 1})$$

Then, the sequential circuit can be described as a nonlinear system by synthesizing the results of fundamental calculations given by Eq. 1. Let $u(t) \in R^j$ be the input value to the sequential circuit. Let $x(t) \in R^i$ be a pseudo-primary input value. Let $y(t) \in$ be a pseudo-primary output value. Let $z(t) \in R^p$ be an primary output value. An approximated nonlinear system can be formulated as given by Eq. 2.

$Y(t) = g(u(t), x(t))$
$z(t) = h(u(t), x(t))$     (Eq. 2)

Since this analog logic calculator portion makes use of a nonlinear system that approximates a sequential circuit, the structure of the sequential circuit is directly reflected. Therefore, the required storage capacity is much smaller than in the prior art techniques.

Referring also to Fig. 8, a differentiated value-calculating portion 2 is a means for calculating a Jacobian matrix of the pseudo-primary output value y(t) with respect to the input value u(t) as given by Eq. 3.

$$\frac{\partial y(t)}{\partial u(t)} = \left[ \frac{\partial y_m(t)}{\partial u_n(t)} \right]$$

(Eq. 3)

where $1 \le m \le i, \quad 1 \le n \le j$

A digital logic simulator 3 is a means for calculating the digital logic value of the sequential circuit in accordance with Eq. 4. With respect to digital logic values, logic 0 is expressed by -1. Logic 1 is expressed by 1. An unknown logic condition is expressed by 0. Let $x\_logic(t)$ be a pseudo-primary input value. Let $y\_logic(t)$ be a pseudo-primary output value. Let $z\_logic(t)$ be an primary output value. Functional relations between inputs and outputs are given by $g\_logic$ and $h\_logic$.

$y\_logic(t) = g\_logic(u(t), x\_logic(t))$
$z\_logic(t) = h\_logic(u(t), x\_logic(t))$     (Eq. 4)

An information amount-calculating portion 4 is a means for calculating an amount of information $P(t)$ defined by an inverse matrix of a covariance matrix of the pseudo-primary output value in accordance with Eq. 5.

$$P(t) = P(t-1) - P(t-1) \frac{y(t)y^t(t)}{1 + y^t(t)P(t-1)y(t)} P(t-1)$$

(Eq. 5)

An evaluated value-calculating portion 5 is a means for calculating an evaluated value $J(t)$ from an information amount $P(t-1)$ and from the pseudo-primary output value $y(t)$ in accordance with Eq. 6. If Eqs. 2 and 5 are taken into consideration, the evaluation function given by Eq. 6 is a function of only the input value $u(t)$ at each instant of time.

$J(t) = y^t(t)P(t-1)y(t)$     (Eq. 6)

An evaluated value partial differential coefficient-calculating portion 6 is a means for calculating the partial differential coefficient $\partial J(t)/\partial u(t) \in R^j$ of the evaluated value $J(t)$ with respect to the input value $u(t)$ in accordance with Eq. 7.

$$\frac{\partial J(t)}{\partial u(t)} = 2y(t)^t P(t-1) \frac{\partial y(t)}{\partial u(t)}$$

$$(Eq. 7)$$

A state transition-managing portion 7 is a means for managing the information related to state transitions searched at each instant of time.

An initial value-setting portion 8 is a means for initializing the analog logic calculator portion 1, the digital logic simulator 3, the information amount-calculating portion 4, and the state transition-managing portion 7.

An input-setting portion 9 is a means for setting an input value when inputs are searched. Also, the setting portion 9 acts to select input bits which by no means affect the pseudo-primary output value from the Jacobian matrix (Eq. 3) calculated by the differentiated value-calculating portion 2.

A clock generator 10 is a means for outputting a clock signal to the analog logic calculator portion 1 and to the digital logic simulator 3, to advance the time incrementally.

Signal lines 101-113 interconnect various blocks. The contents of the signals transmitted over these signal lines will be described in detail in the description of the operation of the present embodiment.

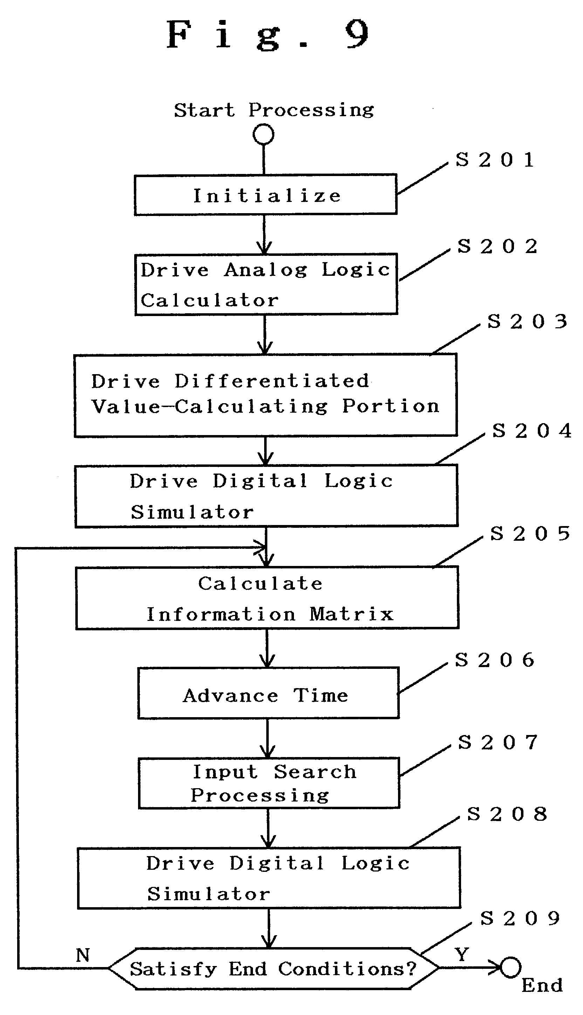

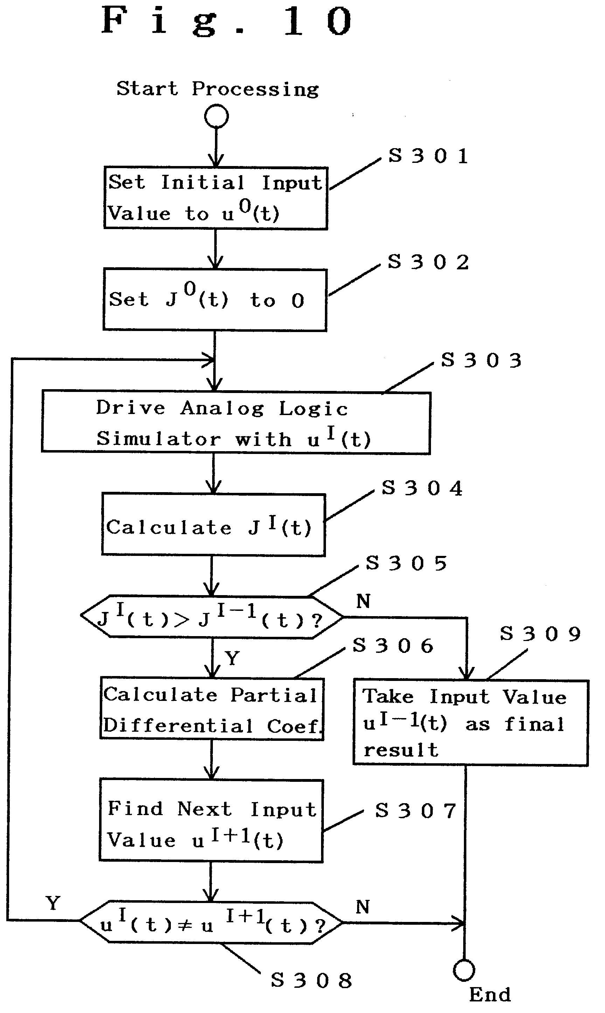

Fig. 9 is a flowchart illustrating the operation of the state transition graph generator of the above-described embodiment. Fig. 10 is a flowchart illustrating the operation of the input search processing 207 of Fig. 9 in greater detail.

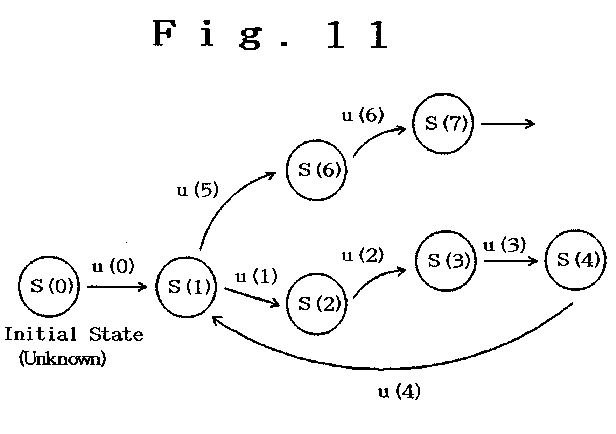

Before the operation of the state transition graph generator of the present embodiment is described in detail, the concept shall be briefly described. The present embodiment is intended to extract a state transition graph from the sequential circuit expressed in terms of logic elements, the state transition graph containing information about the operation. In particular, states of the sequential circuit are searched from an unknown initial state in the depth-first manner. Fig. 11 conceptually illustrates the search. This is known as a depth-first search and is a method of searching for one state which can be reached at the next time from a given state, and then a state that can be reached at the further next time can be explored from the searched state along a straight line.

In order to efficiently obtain a state transition graph for the sequential circuit, inputs should be found that cause the pseudo-primary output value from the sequential circuit to take various values at each instant of time. For this purpose, in the present embodiment, an evaluation function which is maximized if the pseudo-primary output assumes various values is introduced. The problem of the generation of the state transition graph ends in the problem of maximizing this evaluation function which is given by Eq. 6, and based on the amount of information about the hysteresis of the pseudo-primary output value at each instant of time, the information being stored in the form of an inverse matrix of a covariance matrix, as given in Eq. 5. This evaluation function is maximized when the output value differs from the previously stored pseudo-primary output values. Then, an input which maximises this evaluation function is searched at each instant of time. A nonlinear search method is introduced for this search. First, as given by Eqs. 1 and 2, the sequential circuit is formulated as a nonlinear system. Then, an input which maximizes the evaluation function is searched at each instant of time, by making use of information about the partial differential coefficient of the evaluation function with respect to the input. Since the information about the partial differential coefficient indicates the direction of the search for the input that maximizes the evaluation function, the number of trial searches can be reduced.

When the time of the nonlinear system is updated to enhance the degree of approximation to the nonlinear system, a pseudo-primary output value of digital logic as given by Eq. 11 is used. There is a possibility that a nonlinear system approximating a sequential circuit deviates greatly from the behavior of digital logic. However, the nonlinear system can be made to follow the behavior of digital logic by using the pseudo-primary output value of digital logic. This can ensure the validity of the input search utilizing differential information.

The input-setting portion 9 is capable of distinguishing input bits which do not affect the pseudo-primary output at all. Therefore, when such input bits are present, the space in which inputs are being searched can be narrowed. Hence, the amount of calculation needed for the search can be reduced.

The state transition graph generator of the present embodiment which essentially operates as described thus far is next described in further detail by referring to Figs. 8, 9, and 10. This state transition graph generator has two modes of operation. With respect to the second mode of operation, only those points which are different from the first mode of operation will be described.

(step 201)

The initial value-setting portion 8 initializes the analog logic calculator portion 1 and the digital logic simulator 3 in such a way that the logic values of their flip-flops are unknown as given by Eqs. 8 and 9.

$$x_m(0) = 0.0 \quad \text{where } 1 \leq m \leq i \quad \text{(Eq. 8)}$$

$$x\_logic_m(0) = 0 \quad \text{where } 1 \leq m \leq i \quad \text{(Eq. 9)}$$

The initial value-setting portion 8 supplies all the bits of the input value $u(0) \in R^j$ as - 1.0 indicating logic 0 to the signal line 101, initializes an amount of information P(-1) at a unit matrix, and sends it to the signal line 106. The state transition-managing portion 7 initialises all information about state transition in empty states.

(step 202)

The analog logic calculator portion 1 executes a calculation (t = 0) given by Eq. 2, using the input value u(0) delivered to the signal line 101. Then, the calculator portion 1 outputs a pseudo-primary output value y-(0) to the signal line 104.

(step 203)

This step is processing only for the second mode of operation. The differentiated value-calculating portion 2 calculates a Jacobian matrix of the pseudo-primary output value given by Eq. 3 with respect to the input value. The result is sent to the signal line 105. The input-setting portion 9 finds those input bits (hereinafter referred to as the invariable input bits) which do not affect the pseudo-primary output value from the Jacobian matrix output to the signal line 105. The invariable input bits make all elements of the corresponding partial differential coefficient assume value 0.0 (i.e., the sensitivity is zero), and this quality is utilized.

First, a decision is made as to whether all partial differential coefficients (Eq. 10) responsive to the pseudo-primary output value $y(0) = (y_1(0), y_2(0), ..., y_i(0)) \in R^i$ for all the bits of the input value $u(0) = (u_1-(0), u_2(0), ..., u_j(0)) \in R^j$, are 0.0.

$$\frac{\partial\, y_m(t)}{\partial\, u_n(t)} \qquad (1 \leq m \leq i) \qquad \text{(Eq. 10)}$$

If an input bit exists which makes all the elements of Eq. 10 assume value 0.0, then the input-setting portion 9 regards it as an invariable input bit, and outputs it to the signal line 101 while letting the value of the corresponding input bit take value 0 to appear as an unknownness. In this way, invariable input bits which do not affect the pseudo-primary output value can be extracted from the subject of searched inputs. This narrows the space in which inputs are searched, and reduces the amount of calculation.

(step 204)

The digital logic simulator 3 executes the calculation (t = 0) given by Eq. 4, using the input value u(0) output to the signal line 101. Then, the simulator 3 outputs the input value u(0), the pseudo-primary output value x_logic(0), and the pseudo-primary output value y_logic(0). The state transition-managing portion 7 stores the pseudo-primary output value x_logic(0), the pseudo-primary output value y_logic(0), and the input value u(0) as information regarding state transition at instant 0 output to the signal line 102.

Subsequent to step 205, processing taking the form of a loop is run. Therefore, in the following description, an expression "time t" is generally adopted (the first operation is performed at t = 0).

(step 205)

The information amount-calculating portion 4 performs the calculation given by Eq. 5, using the pseudo-primary output value y(t) supplied to the signal line 104, to calculate the amount of information P(t) at the time t. Furthermore, the calculating portion 4 outputs this amount P(t) to the signal line 106. This processing is equivalent to introducing the hysteresis of the pseudo-primary output value at the time t into the amount of information. Since the dimension of the amount of information P(t) is the bit number i of the flip-flops at most, the required storage capacity is very small.

(step 206)

Under instructions output to the signal line 113 from the clock generator 10, the times of the analog logic calculator portion 1 and of the digital logic simulator 3 are updated in accordance with Eqs. 11 and 12, respectively, so that t + 1 is replaced by t. As given by Eq. 11, the analog logic calculator portion 1 updates the state, utilizing the pseudo-primary output value y_logic(t) of digital logic output to the signal line 112. Consequently, the nonlinear system follows the behavior of digital logic. This assures validity of search for inputs, making use of differential information.

$$x\_(t+1) = y\_logic(t) \quad (Eq. 11)$$

$$x\_logic(t+1) = y\_logic(t) \quad (Eq. 12)$$

(step 207)

This is a step for searching for an input which maximizes the evaluation function (Eq. 6) at time t. The operation will be described in connection with step 301 and the following steps. At the end of step 207, the optimum input value u(t) determined as a result of the search is output to the signal line 101. The result of calculation of the pseudo-primary output value y(t) in response to the input value is output to the signal line 104.

(step 208)

The digital logic simulator 3 executes a calculation given by Eq. 4, using the input value u(t) output to the signal line 101, and outputs the input value u(t), the pseudo-primary input value x_logic(t), and the pseudo-primary output value y_logic(t) to the signal line 102. The state transition-managing portion 7 stores the pseudo-primary input value x_logic(t), the pseudo-primary output value y_logic(t), and the input value u(t) as information regarding the state transition at the time t, the information being output to the signal line 102.

(step 209)

The state transition-managing portion 7 determines from the information about the state transitions stored from time 0 to time t whether the following condition is satisfied; a transition to a completely novel state is not discovered when two or more transitions from the present state to the next state are made for every state which varied up to time t. If it is met, the entire operation is ended.
Step 207, or the processing performed to search for inputs, will be described in detail with reference to Figs. 8 and 10. In this step, an input which maximizes the evaluation function (Eq. 6) at the time t is searched according to the partial differential coefficient of the evaluated value with respect to the input value.

(step 301)

The input-setting portion 9 inverts about half of the bits of the input value $u(t-1) \in R^j$ appearing at the immediately preceding time, the half bits having small absolute values of the partial differential coefficient,

$\partial J(t-1)/\partial u(t-1) \in R^j$

at the immediately preceding time. Where j is an odd number, j is replaced by (j + 1)/2. The inverted bits are taken as an initial input value $u^0(t)$ and output to the signal line 101. In the second mode of operation, invariable input bits are held at 0, indicating unknownness, and are extracted from the subjects of the above-described evaluation.

(step 302)

The evaluated value-calculating portion 5 sets an initial evaluated value $J^0(t)$ at 0.

Since the step 303 and subsequent steps are processed in the form of a loop, a general description using a processing number I will be made (in the first step, I = 1)

(step 303)

The analog logic calculator portion 1 calculates a pseudo-primary output value $y^I(t)$ in accordance with Eq. 2, using the input value $u^I(t) \in R^j$ output to the signal line 101. The result is supplied to the signal line 104. All the values of the signal lines in the combinatorial circuit section of the sequential circuit are output to the signal line 103.

(step 304)

The evaluated value-calculating portion 5 calculates an evaluated value $J^I(t)$ from the pseudo-primary output value $y^I(t)$ output to the signal line 104 and from the amount of information P(t-1) at the immediately preceding in accordance with Eq. 6, the amount of information being output to the signal line 106.

(step 305)

The evaluated value-calculating portion 5 compares the evaluated value $J^I(t)$ calculated at step 304 with the evaluated value $J^{I-1}(t)$ calculated in the immediately preceding loop. If $J^I(t) > J^{I-1}(t)$, control goes to step 306; otherwise control proceeds to step 309.

(step 306)

The differentiated value-calculating portion 2 calculates a Jacobian matrix of the pseudo-primary output value with respect to the input value in accordance with Eq. 3, using every signal line value output to the signal line 103. The result is output to the signal line 105. In the second mode of operation, all the elements of the Jacobian matrix for invariable input bits are taken as 0.0 and removed from the subjects of calculation.

Then, the evaluated value partial differential coefficient-calculating portion 6 calculates the partial differential coefficient $\partial J^I(t)/\partial u^I(t) \in R^j$ of the evaluated value in accordance with Eq. 7, using the data appearing at the signal line 105, the amount of information P(t-1) output to the signal line 106, and the pseudo-primary output value $y^I(t)$ output to the signal line 104. The result is output to the signal line 108. In the second mode of operation, the partial differential coefficient of the evaluated value for invariable input bits is taken as 0.0 and removed from the subjects of calculation. Information regarding the calculated partial differential coefficient of the evaluated value indicates the direction of search for an input which maximizes the evaluation function. In the second mode of operation, the amount of calculations for the Jacobian matrix given by Eq. 3 and for the partial differential coefficient of the evaluated value (Eq. 7) can be reduced.

(step 307)

The input-setting portion 9 finds the following input value $u^{I+1}(t)$ according to the rules described below, using the evaluated value partial differential coefficient $\partial J^I(t)/\partial u^I(t) \in R^j$ output to the signal line 108. The signs of the bits of the partial differential coefficient of the evaluated value and the signs of the bits of inputs are compared. If unlike signs are present, then the corresponding bits of inputs are inverted and taken as the next input value $u^{I+1}(t)$. Also, these bits are output to the signal line 101. In the second mode of operation, invariable input bits are not changed and are removed from the subject of evaluation. The invariable input bits are maintained at 0, indicating unknownness.

In this way, input bits are modified along the direction in which an input maximizing the evaluation function is searched, and therefore the number of trial searches for the input can be reduced. In the second mode of operation, the invariable input bits are not altered and thus the amount of calculation can be reduced.

(step 308)

The input-setting portion 9 compares the input value $u^l(t)$ and the next input value $u^{l+1}(t)$ and determines whether a modification has been made (step 307). If it has been made, $l + 1$ is replaced by $l$, and control returns to step 303. If no modification has been made, the processing for searching for the input is ended.

(step 309)

The input-setting portion 9 outputs the immediately preceding input value $u^{l-1}(t)$ to the signal line 101. The analog logic calculator portion 1 computes a pseudo-primary output value $y^{l-1}(t)$ in accordance with Eq. 2, using the input value $u^{l-1}(t) \in R^j$ output to the signal line 101. The result is output to the signal line 104. Then, the processing for searching for the input is ended.

In step 203, the input-setting portion 9 used information about the Jacobian matrix given by Eq. 3 in distinguishing input bits which by no means affect the pseudo-primary output value. Instead, the partial differential coefficient of the evaluated value with respect to the input value as given by Eq. 7 can be used.

As described thus far, in the first embodiment of the novel state transition graph generator, the evaluation function serves to reduce the evaluated value on states different from states stored in the covariance matrix. Hence, a state transition graph can be created by searching for inputs so as to minimize this evaluated value. In the present embodiment, state transition graphs are searched by the depth-first method and, therefore, states which can be reached long after the initial state can be effectively searched well.

The analog logic calculator portion 1 acts only to cause logic elements in the sequential circuit to take an analog form. In consequence, the storage capacity required for circuit conversion is much smaller than in the prior art techniques.

Furthermore, the amount of information P(t) is a matrix having at most the dimension of the bit number of flip-flops, thus greatly reducing the storage capacity required. This makes it possible to create a state transition graph even for a sequential circuit having 2000 or more gates.

In addition, states are searched by making use of the direction in which an evaluated value decreases most steeply with respect to the input value and so the amount of calculation needed for the search can be reduced.

Moreover, where input bits which do not affect pseudo-primary output values or states are detected and such primary input bits are present, the space in which inputs are searched is narrowed, so that the amount of calculation needed for the search can be reduced.

The concept of a second embodiment of the state transition graph generator of the present invention is described next.

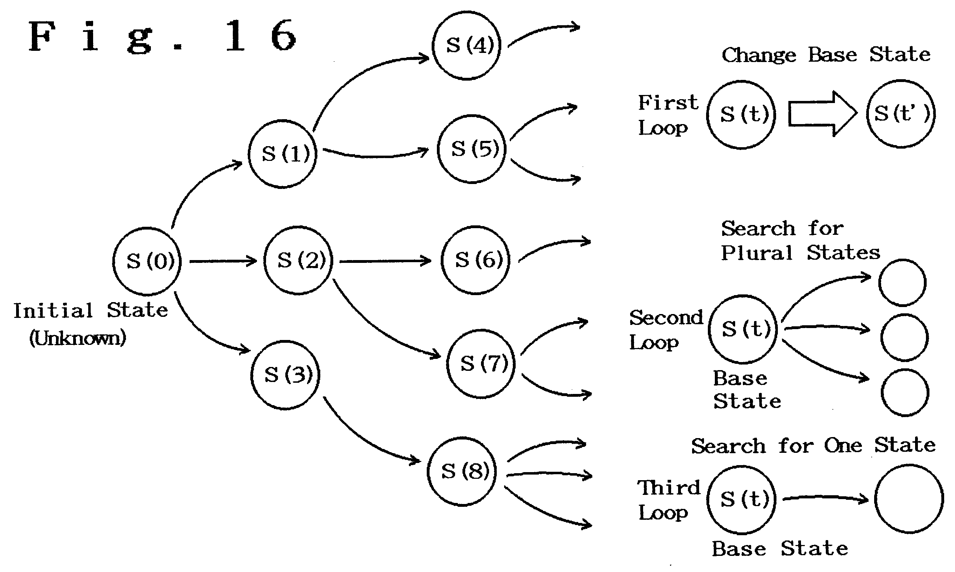

In the present embodiment, a state transition graph for a sequential circuit is extracted from an unknown initial state in the breadth-first manner. Fig.16 conceptually illustrates this embodiment. A breadth-first search is a method of searching for as many states as possible which can be reached at the next time from a given base state to extract a state transition graph, as illustrated in Fig. 16.

This search method is carried out by establishing an evaluation function suitable for a search for states and searching for input values so as to minimize the evaluation function. For the minimization of the evaluation function, the partial differential coefficient of the evaluated value with respect to the input value, i.e., information regarding the direction of the steepest descent, is used. To permit this, digital logic is made to assume an analog form by a nonlinear function. The evaluation function is based on the amount of information about the hysteresis of states stored in a covariance matrix and serves to reduce the evaluated values on states different from the stored states. Mathematically, where a state composed of plural bits is taken as a vector, states which are more closely perpendicular to the vector of the stored state have small evaluated values.

The second embodiment of the novel state transition graph generator is nesting of three loops. The loop processing at the highest level is referred to as the first loop. The loop processing at the intermediate level is referred to as the second loop. The loop processing at the lowest level is referred to as the third loop.

15

This type of loop processing is described successively with reference to Fig. 16.

(first loop)

In the inventive state transition graph generator, flip-flops of a sequential circuit start from an unknown state. The reached state is used as a base state. Then, every state which can be reached from this base state is searched. When a search for states from the base state ends, a search for states is repeated while employing the newly reached state as the next base state. This processing is continued until an access to a new base state is no longer possible. In this way, the first loop is processed for searching for states while repeatedly resetting a base state.

(second loop)

This is a loop for searching for every state which can be reached from one base state. In particular, a plurality of searches for states are performed with plural initial input values produced at random. Plural states which can be reached from one base state can be searched by repeating this loop. This loop is ended if access from the base state to a new state fails three times.

(third loop)

This is a loop for searching for input values so as to minimize the evaluated value to search for one state which can be reached from a base state. Specifically, starting from an initial input value, an input value that minimizes the evaluated value is searched by utilizing information regarding the direction of the steepest descent of the evaluated value with respect to the input value. Since the direction of the steepest descent of the evaluated value with respect to the input value indicates the direction of search to minimize the evaluated value, the number of trial searches for inputs can be reduced by modifying the input value along this direction. To enable this, logic elements are made to take an analog form by a nonlinear function.

The second embodiment of the novel state transition graph generator shall now be described with reference to the drawings.

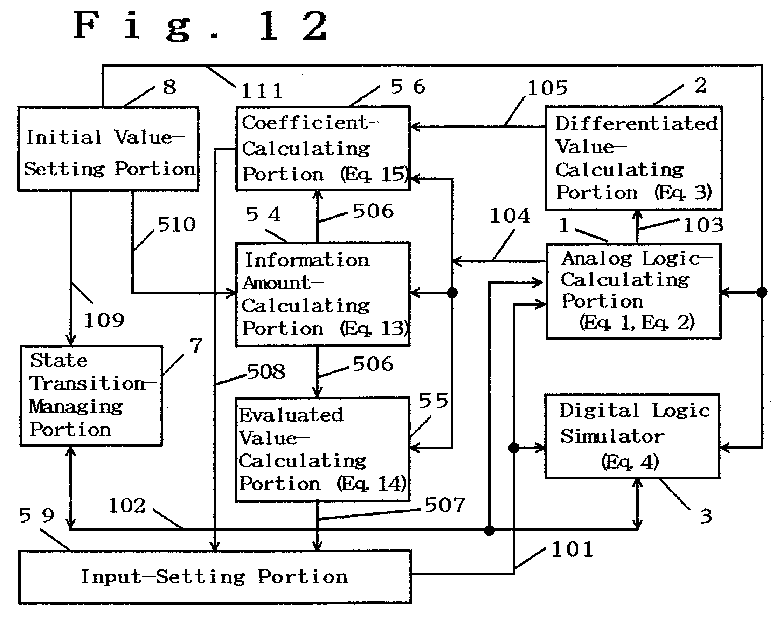

Fig. 12 shows the structure of the state transition graph generator of the present embodiment. To simplify the illustration, only the differences with the first embodiment are described. An information amount-calculating portion 54 is a means for performing calculations to store the hysteresis of a pseudo-primary output value in a covariance matrix. The amount of information M(k) defined by a covariance matrix is defined by Eq. 13.

$$M(k) = M(k-1) + y(k)y^t(k) \qquad \text{(Eq. 13)}$$

where y(k) is a pseudo-primary output value, or state, calculated by the analog logic calculator portion, and k indicates the number of searches for inputs in the second loop of Fig. 16.

An evaluated value-calculating portion 55 is a means for calculating an evaluated value J(k) in accordance with Eq. 14 from an amount of information M(k-1) and from a pseudo-primary output value y(k). This evaluated value decreases toward its minimum value as the difference between the hysteresis of the pseudo-primary output value stored in the amount of information M(k-1) and the pseudo-primary output value y(k) increases.

$$J(k) = y^t(k)M(k-1)y(k) \qquad \text{(Eq. 14)}$$

An evaluated value partial differential coefficient-calculating portion 56 is a means for calculating the partial differential coefficient $\partial J(k)/ \partial u(k) \in R^j$ of the evaluated value J(k) with respect to the input value u(k) in accordance with Eq. 15. Since this partial differential coefficient is in the direction of the steepest descent of the evaluated value with respect to the input value, the coefficient indicates the direction of search for an input which minimizes the evaluated value.

$$\frac{\partial J(k)}{\partial u(k)} = 2y(k)^t M(k-1) \frac{\partial y(k)}{\partial u(k)}$$

(Eq. 15)

An input-setting portion 59 is a means for estimating the direction of search for an input minimizing the evaluated value from the evaluated value partial differential coefficient output from the partial differential coefficient-calculating portion 56 and for searching for an input value that minimizes the evaluated value repeatedly.

Signal lines 101-111, 506-510 interconnect the various blocks. Signals transmitted over these lines are described in detail in connection with the description of the operation of the invention.

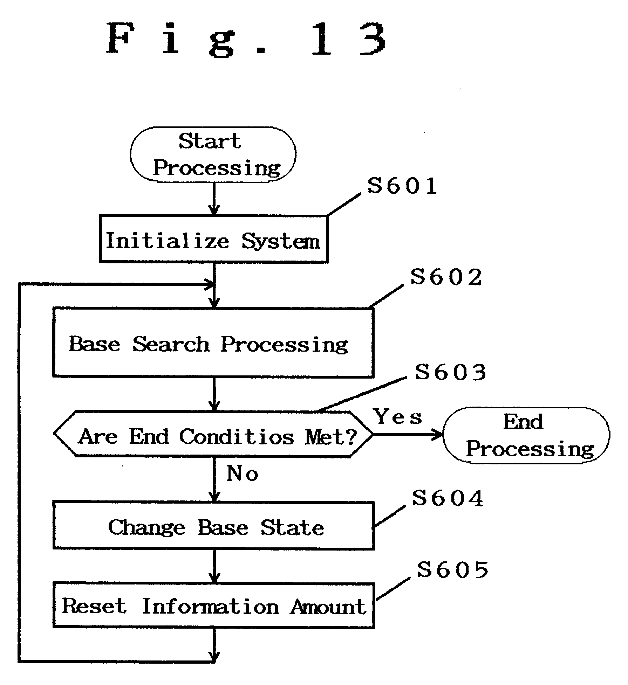

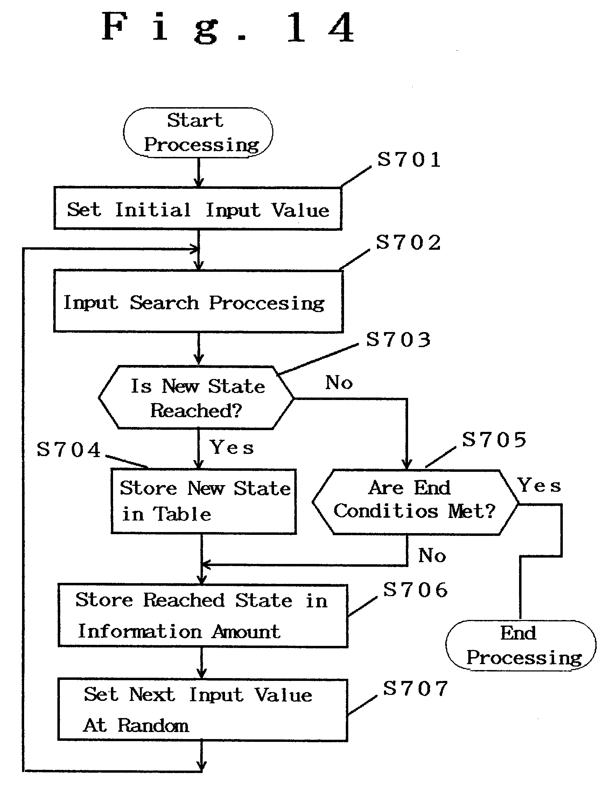

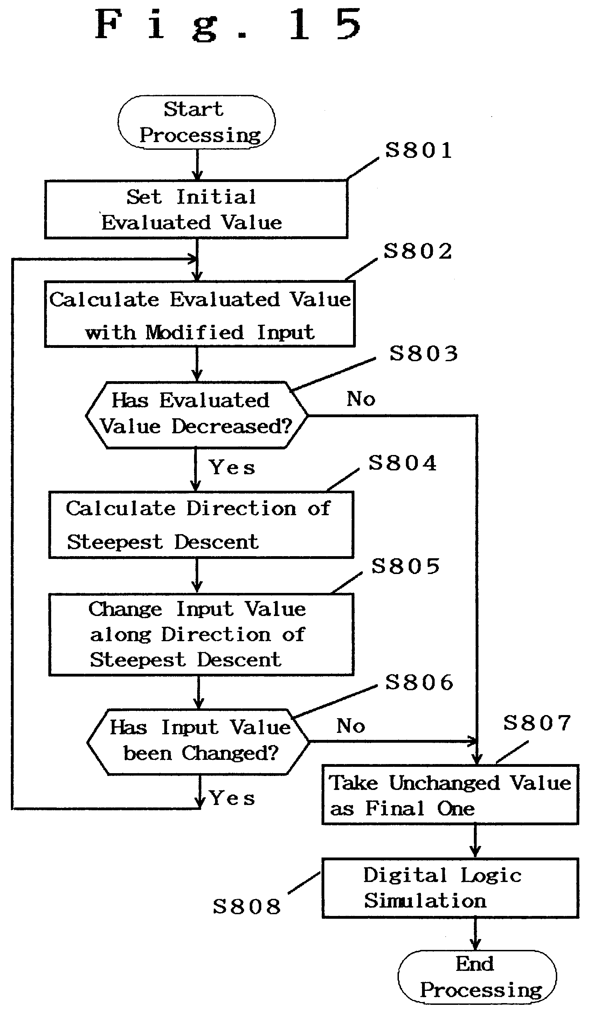

Figs. 13, 14, and 15 are flowcharts illustrating the operation of the state transition graph generator in the present embodiment, corresponding to the aforementioned first, second, and third types of loop processing.

The operation of the second embodiment of the novel state transition graph generator constructed as described above will be described in detail with reference to Figs. 12, 13, 14, and 15. The state transition graph generator of the present embodiment has two modes of operation. With respect to the second mode of operation, only those points which differ from the first mode of operation will be described. First, the whole processing corresponding to the first loop is described with reference to Figs. 12 and 13.

(step 601)

In the same way as in the first embodiment, the initial value-setting portion 8 initializes the analog logic calculator portion 1, the digital logic simulator 3, and the state transition-managing portion 7. The initial value-setting portion 8 initializes the amount of information M(0) of the information amount-calculating portion 54 at 0 matrix. The amount of information M(0) is output to the signal line 506. This is processing for resetting the hysteresis of a state. The input-setting portion 59 outputs every bit of the input value $u(0) \in R^j$ to the signal line 101 as - 1.0 indicating logic 0.

The following processing is done only during second mode of operation. The next processing is performed to judge those input bits (invariable input bits) which do not affect the pseudo-primary output value. Invariable input bits make all the elements of the corresponding partial differential coefficients assume value 0.0, or sensitivity zero, and this quality is utilized. The analog logic calculator portion 1 executes the calculation (t = 0) given by Eq. 2, using the input value u(0) output to the signal line 101, and supplies a pseudo-primary output value y(0) to the signal line 104. The differentiated value-calculating portion 2 calculates a Jacobian matrix of the pseudo-primary output value given by Eq. 3 with respect to the input value, and supplies the result to the signal line 105. The input-setting portion 59 finds invariable input bits from the Jacobian matrix supplied to the signal line 105. In particular, checks are made to see if all partial differential coefficients (Eq. 10) responsive to pseudo-primary output values $y(0) = (y_1(0), y_2(0), ..., y_i(0)) \in R^i$ for each bit of the input value $u(0) = (u_1(0), u_2(0), ..., u_j(0)) \in R^j$ take value 0.0. If invariable input bits exist, the values of the bits are fixed at 0.0, indicating unknown logic.

(step 602)

Base search processing is performed. This processing is done to search for plural states which can be reached from a base state. The operation will be described in detail in connection with steps 701-707 described later.

(step 603)

The conditions under which the operation of the system ends are checked. As described later, states which can be reached from an initial state are stored in the state transition-managing portion 7, together with input sequences leading to these states. The managing portion 7 determines whether a state not selected as a base state is present. If such a state is absent, the search for states is ended.

(step 604)

A new base state is established. The state transition-managing portion 7 outputs a state which has not been selected as a base state in the past to the signal line 102. The analog logic calculator portion 1 and the digital logic simulator 3 store the base state output to the signal line 102 in flip-flops.

(step 605)

The amount of information is reset. The initial value-setting portion 8 resets the amount of information of the information amount-calculating portion 4 at 0 matrix (M(0)).

Processing for search for plural states, corresponding to the second loop (step 602), is described next with reference to Figs. 5 and 7.

(step 701)

An initial input value is set. An input value entered at the end of the immediately preceding search for base states is established as an initial input value $u^0(0)$ by the input-setting portion 59 which then supplies the set input value to the signal line 101.

Since loop processing is performed successively, a number of loops k are used in the following description. In this processing, plural states which can be reached from a base state are searched, using plural initial input values produced at random.

(step 702)

Input search processing is performed. This processing starts from the initial input value $u^0(k)$ and searches for one state which can be reached from a base state while repeatedly modifying an input value that minimizes the evaluated value. The operation will be described in detail in conjunction with steps 801-808 described later.

(step 703)

Whether a new state is reached as a result of a search for inputs is determined. The state transition-managing portion 7 compares the result of the search for states output to the signal line 102 and the hysteresis of the previously reached states stored in a table and determines whether a new state is reached. If it is reached, control goes to step 704. If it is not reached, control proceeds to step 705.

(step 704)

The newly reached state is stored in a table within the state transition-managing portion 7. This managing portion 7 stores the state output to the signal line 102 and a search final input u(k) in the table.

(step 705)

The conditions under which the processing for the search for base states ends are checked. If access to a new state fails three times in total, the state transition-managing portion 7 terminates the base search processing. If the number of faults is less than three, control goes to step 706.

(step 706)

The pseudo-primary output value is stored in the amount of information. The information amount-calculating portion 54 stores the pseudo-primary output value y(k) output to the signal line 104 in the amount of information M(k) in accordance with Eq. 13.

(step 707)

The next initial input value is set. The input-setting portion 59 sets the next initial input value u(k + 1) at random. Control returns to step 702 after replacing k + 1 with k.

18

Finally, input search processing (step 702), corresponding to the third loop, is described with reference to Figs. 5 and 8.

(step 801)

An initial evaluated value is set. The evaluated value-calculating portion 55 sets an initial evaluated value $J^{-1}(k)$ to 10000. Subsequently, loop processing is initiated. In the following description, the number of loops I is used. At first, I = 0. This processing is performed, by using the direction of the steepest descent. An input value which minimizes the evaluated value is searched from the initial input value, and this search is repeated.

(step 802)

An evaluated value for the input value $u^l(k)$ is calculated. The analog logic calculator portion 1 performs a calculation in accordance with Eq. 2, using the input value $u^l(k)$ supplied to the signal line 101. The calculated pseudo-primary output value $y^l(k)$ is supplied to the signal line 104. All signal line values in the sequential circuit are supplied to the signal line 103. Then, the evaluated value-calculating portion 55 performs a calculation given by Eq. 14, using the pseudo-primary output value $y^l(k)$ supplied to the signal line 104 and the amount of information M(k-1) output to the signal line 506. The computed evaluated value $J^l(k)$ is supplied to the signal line 507.

(step 803)

Whether the evaluated value has decreased in response to the input value $u^l(k)$ is determined. The evaluated value-calculating portion 55 compares the evaluated value $J^l(k)$ responsive to the input value $u^l(k)$ and the evaluated value $J^{l-1}(k)$ responsive to the input value $u^{l-1}(k)$ at the immediately preceding loop. If the evaluated value $J^{l-1}(k)$ is less than the evaluated value $J^l(k)$, it follows that the evaluated value has been minimized at the (I-1)-th loop. If the latter is less than the former, control goes to step 804. If the former is less than the latter, control proceeds to step 807.

(step 804)

The direction of the steepest descent of the evaluated value for the input value $u^l(k)$ is calculated. The differentiated value-calculating portion 2 calculates a Jacobian matrix in accordance with Eq. 3, using the logic values of all signal lines output to the signal line 103. However, in the second mode of operation, the elements of the Jacobian matrix for invariable input bits are all 0.0 and are removed from the subjects of calculation. The result of the calculation is delivered to the signal line 105. Then, the partial differential coefficient-calculating portion 56 performs a calculation given by Eq. 15, using the Jacobian matrix output to the signal line 105 and the pseudo-primary output value $y^l(k)$ output to the signal line 104. The calculated partial differential coefficient of the evaluated value, or the direction of the steepest descent, is supplied to the signal line 508. In the second mode of operation, the elements of the Jacobian matrix for invariable input bits are all 0.0 and are removed from the subjects of calculation. As described above, the amount of calculation is reduced in the second mode of operation.

(step 805)

The input value is modified along the direction of the steepest descent ($u^{l+1}(k)$). The input-setting portion 59 finds the next input value $u^{l+1}(k)$ according to the rules by making use of the direction of the steepest descent of the evaluated value responsive to the input value delivered to the signal line 508. Each bit of the input value $u^{l+1}(k)$ is set to the direction of the sign indicated by the evaluated value partial differential coefficient, or the direction of the steepest descent. That is, if the sign is positive, the corresponding bit of the input value is set to -1.0. If the sign is negative, the corresponding bit is set to +1.0. The result is supplied to the signal line 101. In the second mode of operation, invariable input bits are not changed and are removed from the subjects of evaluation. These invariable input bits are maintained at 0, indicating unknownness.

19

(step 806)

Whether the input value $u^{l+1}(k)$ changed to the direction of the steepest descent is different from the input value $u^l(k)$ obtained prior to the change is determined. If they are exactly coincident, it follows that the input value $u^l(k)$ has realized the optimum value of the evaluated value. The input-setting portion 59 compares the bits of the input value $u^{l+1}(k)$ with the bits of the input value $u^l(k)$. If all of the compared bits agree precisely, then control goes to step 807. If different bits exist, then $l+1$ is replaced by $l$, and control returns to step 802.

(step 807)

The input value $u^{l-1}(k)$ to the immediately previous loop is established as the final input value u(k) in the search. This processing is done to search for the input value $u^{l-1}(k)$, since the results of decisions made in steps 803 and 806 are that the evaluated value is minimized by the (l-1)th loop. The input-setting portion 9 outputs the input value $u^{l-1}(k)$ to the signal line 101. The analog logic-calculating portion 1 performs a calculation given by Eq. 2, using the input value $u^{l-1}(k)$ supplied to the signal line 101. The result of the calculation, or the pseudo-primary output value y(k), is supplied to the signal line 104.

(step 808)

In this step, the digital logic simulator 3 is driven with the final input value u(k) in the search to calculate actual digital logic values. The simulator 3 performs a digital logic calculation given by Eq. 4, using the final input signal u(k) in the search, the signal being delivered to the signal line 101. The final input value u(k) and the reached state y logic(k) are output to the signal line 102. Thus, the processing for searching for inputs is ended.

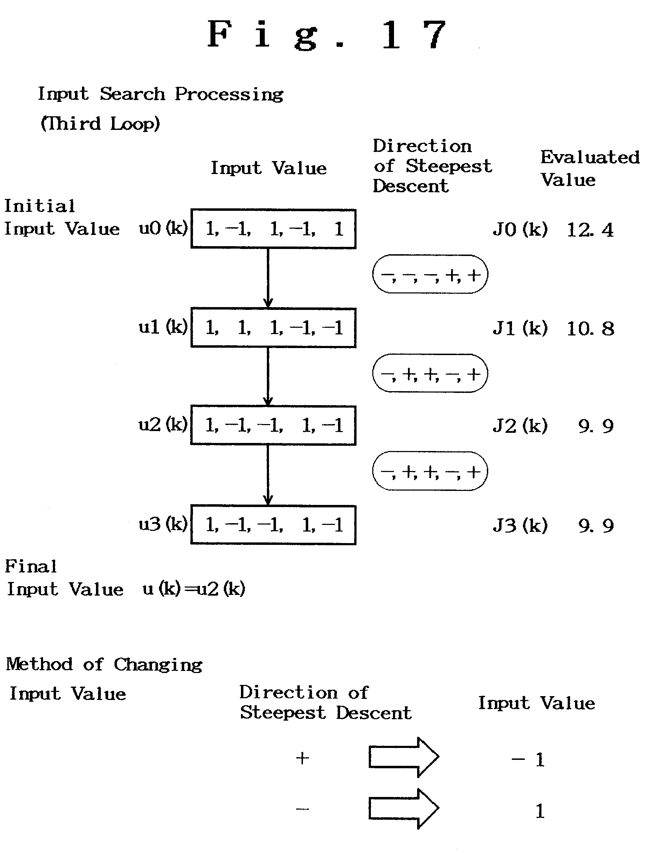

Fig. 17 illustrates one example of the execution of input search processing, and indicates a procedure for searching for an input that minimizes the evaluated value while changing the input value from the initial value $u^0(k)$ in the steepest descent. In this example, $u^2(k)$ is selected as the final input value u(k), because the input value was not changed in step 806 when a change from $u^2(k)$ to $u^3(k)$ was made. Since input values are searched while utilizing information regarding the direction of the steepest descent of the evaluated value in this way, the amount of calculation needed for the search can be reduced.

As described thus far, in the second embodiment of the novel state transition graph generator, a state transition graph is searched by a breadth-first method. Therefore, states which can be reached from an initial state in a short time can be efficiently searched.

Furthermore, in the second embodiment of the invention, the storage capacity needed for circuit conversion and for searches for states, and the storage capacity required for searches for states can be reduced, in exactly the same way as in the first embodiment.

Those input bits which do not affect the pseudo-primary output value are distinguished. If such primary input bits exist, the space in which inputs are searched is narrowed, thus reducing the amount of calculation needed for searches.

A third embodiment of the novel state transition graph generator is described below. The third embodiment differs from the second embodiment in terms of its method of setting an evaluation function. The concept thereof is described below.

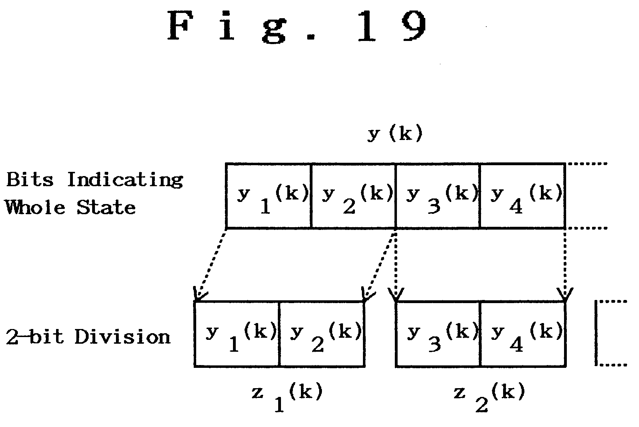

As described in the second embodiment, with respect to an evaluation function based on the amount of information of a covariance matrix, states whose vectors are more closely perpendicular to the state stored previously in the amount of information are reduced to a minimum value. In the second embodiment, an amount of information amount which sees all bits of states as a whole was established. In the third embodiment, an information which sees them locally is added to the amount of information seeing them as a whole. Then, an evaluated value which is a linear sum of evaluations based on those amounts of information is defined. This evaluated value is taken as a reference in searching for new states generally and locally. The locally viewed amount of information is obtained by dividing all bits indicating states in units of 2 bits and storing them in separate covariance matrices. The division into 2 bits is conceptually illustrated in Fig. 19.

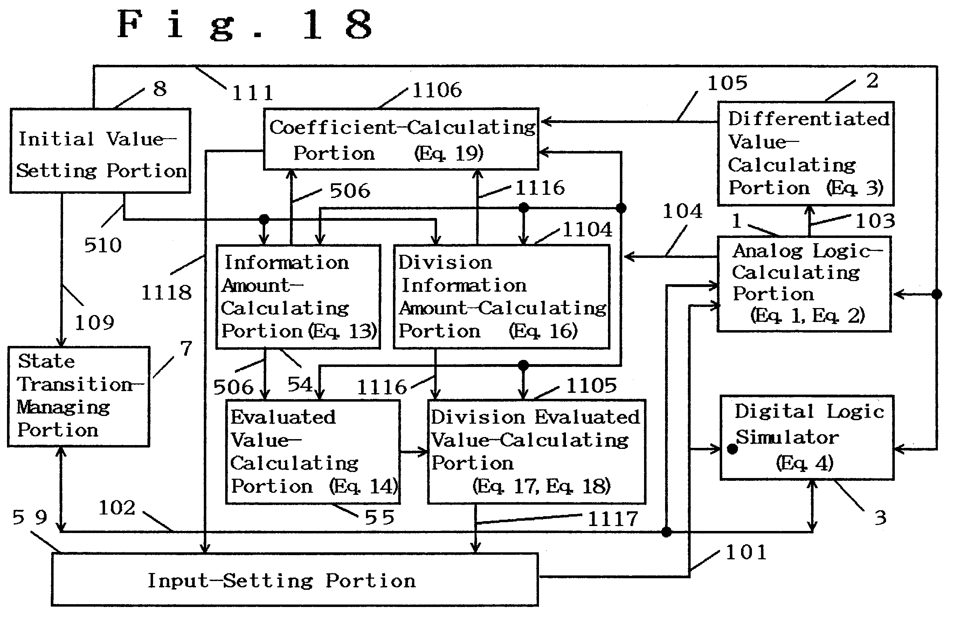

Fig. 18 shows the structure of the third embodiment of the novel state transition graph generator. The third embodiment differs from the second embodiment in that a division information amount-calculating portion 1104 and a division evaluated value-calculating portion 1105 are added and that an evaluated value partial differential coefficient-calculating portion 1106 performs a different calculation. The flow of operation is exactly the same as the flow of Figs. 13,14 and 15. Therefore, only those points of structure which are different from the second embodiment are described; the operation thereof will not be described.

In Fig. 18, the division information amount-calculating portion 1104 is a means for performing calculations to divide the pseudo-primary output value in units of 2 bits and to store them in separate covariance matrices. A calculational formula is indicated in Eq. 16. $D_j(k)$ is an amount of information for dividing bits indicating states in units of 2 bits and storing them in separate covariance matrices, and j indicates a division number. This information amount $D_j(k)$ is information which sees states locally.

$$D_j(k) = D_j(k-1) + z_j(k)z_j^t(k) )  \quad \text{(Eq. 16)}$$

where $z_j(k)$ indicates each state divided in units of 2 bits (see Fig. 19).

The division evaluated value-calculating portion 1105 calculates an evaluated value $J_2(k)$ in accordance with Eq. 17 from an amount of information $D_j(k-1)$ and from a pseudo-primary output value y(k). Also, the calculating portion 1105 calculates an evaluated value J(k) in accordance with Eq. 18, the value J(k) being defined as a linear sum of an evaluated value $J_1(k)$ based on the amount of information M(K) output from the evaluated value-calculating portion 5 and the above evaluated value $J_2(k)$. $J_1(k)$ corresponds to an evaluated value which sees states as a whole. $J_2(k)$ corresponds to an evaluated value which sees states locally.

$$J_2(k) = \sum_j z_j^t(k)D_j(k-1)z_j(k) \quad \text{(Eq. 17)}$$

$$J(k) = a^*J_1(k) + (1-a)^*J_2(k) \quad \text{(Eq. 18)}$$

The evaluated value partial differential coefficient-calculating portion 1106 is a means for calculating the partial differential coefficient $\partial J(k)/\partial u(k) \in R^j$ of the evaluated value J(k) with respect to the input value u(k) in accordance with Eq. 19. This coefficient indicates the direction of the steepest descent of the evaluated value with respect to the input value.

$$\frac{\partial J(k)}{\partial u(k)} = a * \frac{\partial J_1(k)}{\partial u(k)} + (1-a) * \frac{\partial J_2(k)}{\partial u(k)} \quad \text{(Eq. 19)}$$

As described thus far, in the third embodiment of the novel state transition graph generator, the evaluation function serves to reduce evaluated values on states which differ from the state stored in a covariance matrix. Input values are searched so as to minimize this evaluated value. Thus, a state transition graph can be created.

Also, an evaluation function which sees states locally is added and so the ability to search for states is improved over the second embodiment.

Furthermore, in the third embodiment of the invention, the storage capacity necessary for circuit conversion and search for states and the amount of calculation necessary for the search for states can be reduced, in exactly the same way as in the second embodiment.

Additionally, those input bits which do not affect the pseudo-primary output value are judged. If such primary input bits exist, the space in which inputs are searched is narrowed, thus reducing the amount of calculation necessary for search.

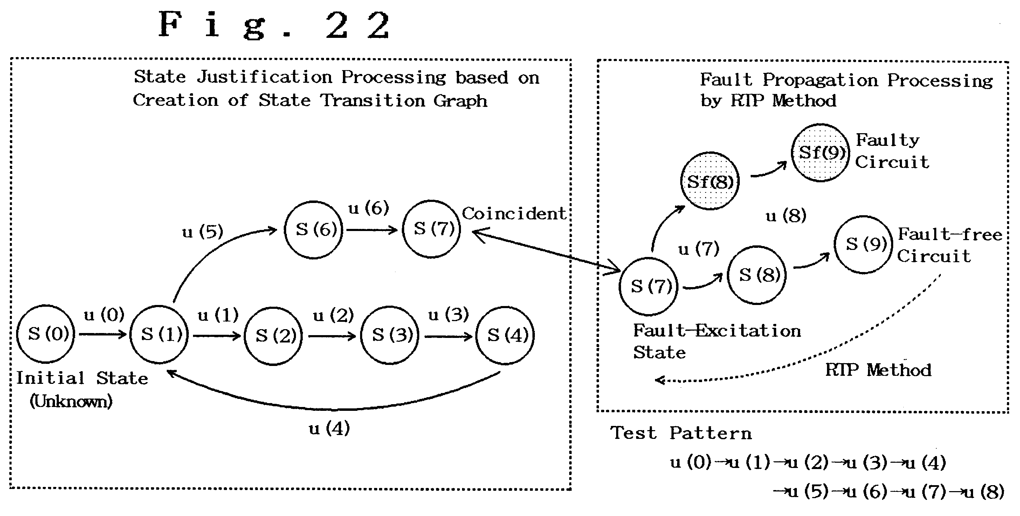

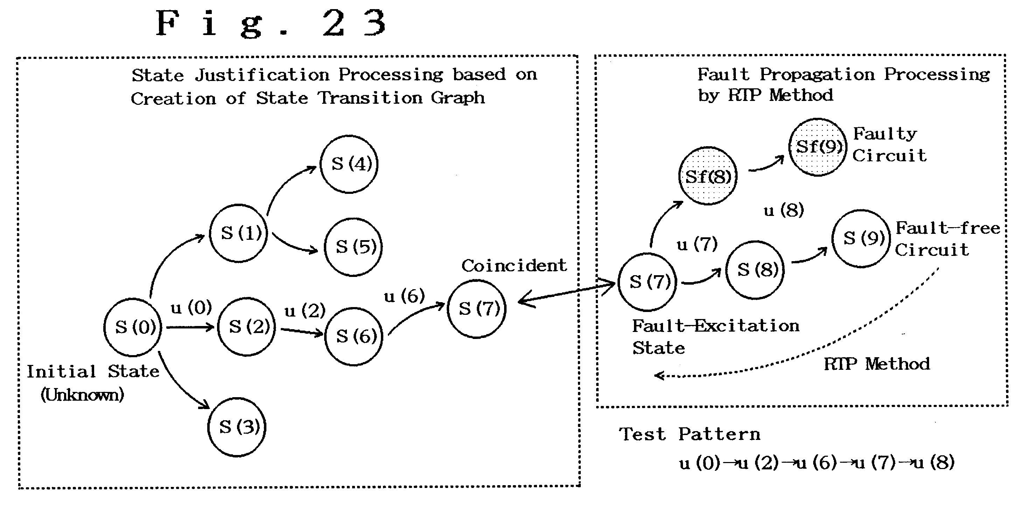

A first embodiment of the novel test pattern generator is described below. This embodiment of the test pattern generator replaces state justification processing in generating a test pattern by the above-described method of creating a state transition graph and performs fault propagation processing by the RTP method. The concept is briefly described now with reference to Figs. 22 and 23. Fig. 22 conceptually illustrates a case in which the depth-first search described in the first embodiment for creating a state transition graph is used as a state transition graph generator means. Fig. 23 conceptually illustrates a case in which the breadth-first search described in the above-described second and third embodiments is employed.

First, a state transition graph is created, using a fault-free sequential circuit, by any one of the above-described embodiments of the state transition graph generator. This corresponds to state justification processing in generating a test pattern. That is, a test pattern for states which can be reached from an arbitrary state is previously created. Then, one fault type is selected. After the selection, fault propagation processing for the fault type is performed by the RTP method to search for a fault excitation state. If the fault propagation processing fails, an input sequence created during the unsuccessful process is taken as a test pattern. If it succeeds, state justification processing is initiated. More specifically, whether a fault excitation state is contained in states which are reached by the state transition graph generator is determined. If such a state is present, the test pattern leading to the fault excitation state and the test pattern generated by the fault propagation processing are connected together, and a test pattern for the fault-excited type is generated.

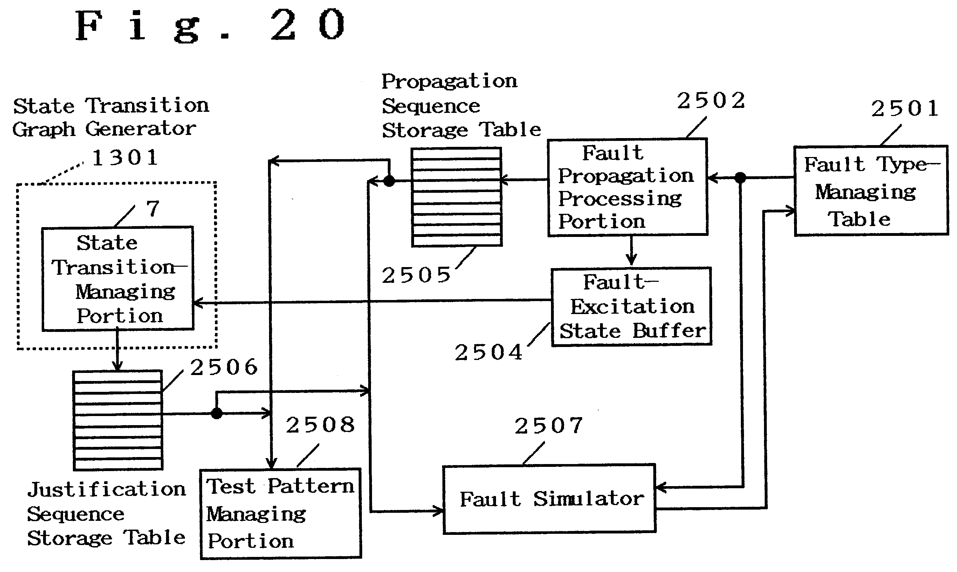

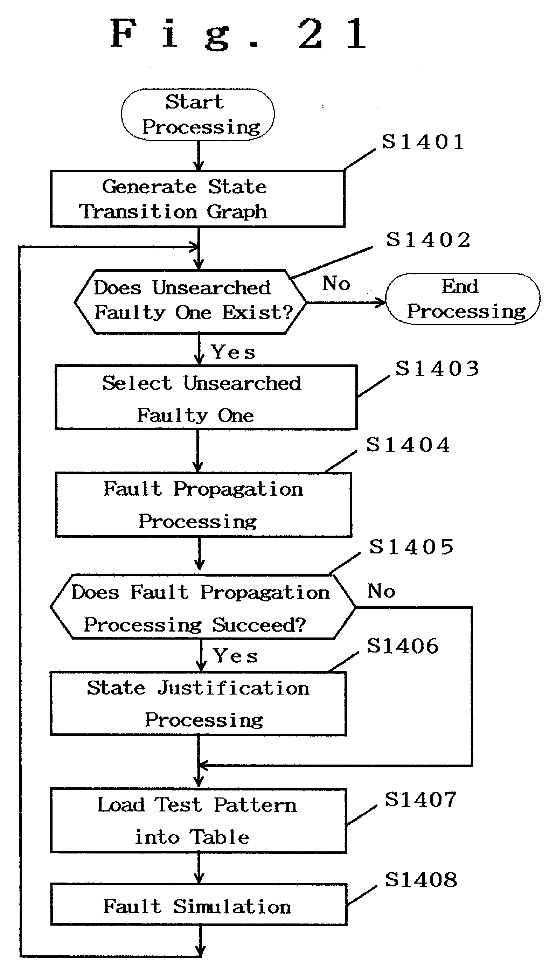

Fig. 20 shows the structure of the first embodiment of the novel test pattern generator. In this figure, a state transition graph generator 1301 consists of the novel state transition graph generator described above. Components 2501-2504, 2506-2508 are exactly the same as their counterparts of the test pattern generator utilizing the RTP method described in connection with the prior art techniques and so detailed description of them is omitted. Fig. 21 is a flowchart illustrating the operation of the first embodiment of the novel test pattern generator.

The operation of the first embodiment of the novel test pattern generator is described hereinafter with reference to Figs. 20 and 21.

(step 1401)

The state transition graph generator 1301 creates a state transition graph for a fault-free circuit in the manner as described already in connection with embodiments of the state transition graph generator.

(step 1402)

The fault type-managing table 2501 performs a check as to whether unsearched fault types exist. If they do not exist, the processing for generating a test pattern is ended.

(step 1403)

The fault type-managing table 2501 selects one out of fault types which are neither detected nor searched.

(step 1404)

The fault propagation processing portion 2502 performs fault propagation processing for the fault type selected in step 1403 by the RTP method. The generated test pattern is output to the propagation sequence storage table 2505.

(step 1405)

The fault propagation processing portion 2502 performs a check as to whether fault propagation processing has been done successfully. If it succeeds, a fault excitation state is delivered to the fault excitation state buffer 2504, and control goes to step 1406. If it fails, control jumps to step 1407.

(step 1406)

The state transition-managing portion 7 performs a check to see if the fault excitation state stored in the fault excitation state buffer 2504 is contained in the states reached by the state transition graph created in step 1401. If it is contained therein, the managing portion 7 stores a test pattern leading from an arbitrary initial state to the coincident state in the justification sequence storage table 2506.

(step 1407)

The test pattern created for the fault type selected in step 1403 is loaded into the test pattern-managing table 2508. Specifically, test patterns stored in the propagation sequence storage table 2505 and in the justification sequence storage table 2506 are loaded in the order of state justification sequence and fault propagation sequence.

(step 1408)

The fault simulator 2507 makes a simulation of a fault, using the test pattern created for the fault type selected in step 1403. Then, information regarding the newly detected fault type is sent to the fault type-managing table 2501. Finally, the propagation sequence storage table 2505 and the justification sequence storage table 2506 are cleared. Control then goes back to step 1402.

In step 1404, the fault propagation processing portion 2502 can repeat the fault propagation processing while varying the method of searching to detect different fault excitation states.

As described thus far, in the first embodiment of the novel test pattern generator, state justification processing is performed for the fault excitation state generated by the RTP method, by making use of the novel state transition graph generator. This improves the performance of the state justification processing and thus improves the fault coverage.

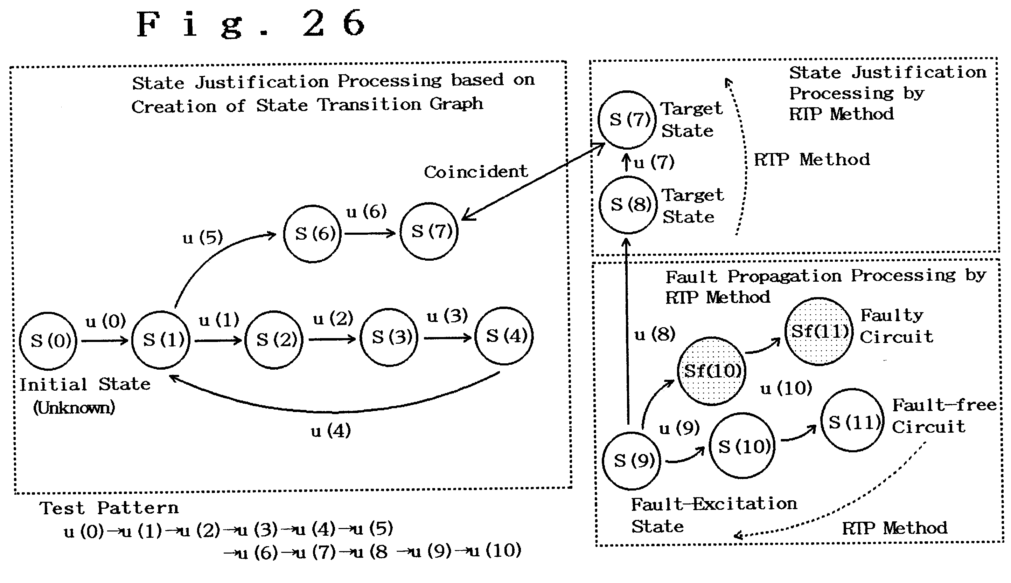

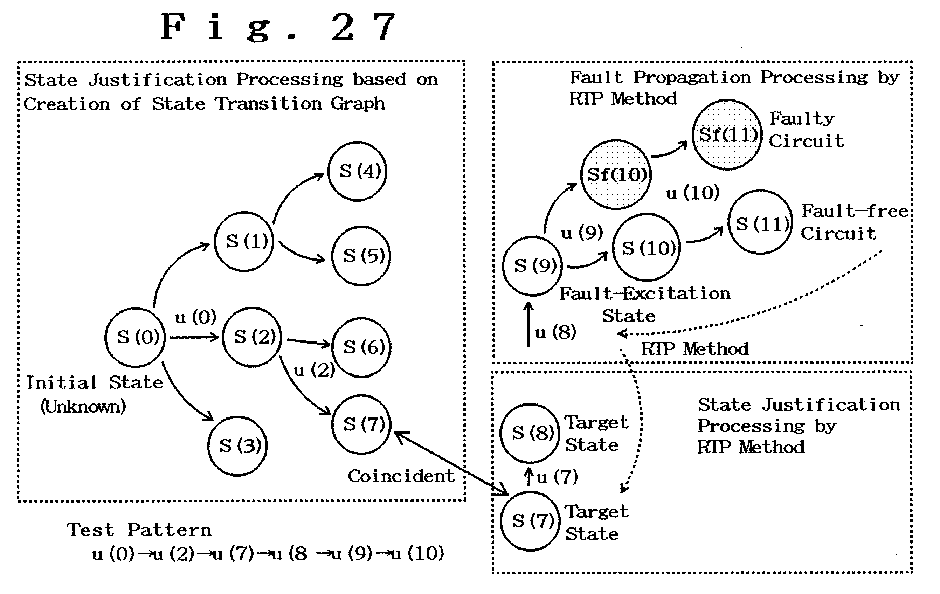

A second embodiment of the novel test pattern generator is described below. This embodiment performs state justification processing in generating a test pattern by utilizing both novel state transition graph generator and test pattern generator based on the RTP method. The concept will be briefly described with reference to Figs. 26 and 27. Fig. 26 conceptually illustrates a case in which the depth-first search described previously in connection with the first embodiment of the state transition graph generator is used as a state transition graph generator means. Fig. 27 conceptually illustrates a case in which the breadth-first search described already in connection with the second and third embodiments of the generator is employed.

First, a state transition graph is created, using a fault-free sequential circuit, by any one of the above-described embodiments of the novel state transition graph generator. By this processing, states which can be reached from an arbitrary initial state and test patterns leading to these states are found. Then, one fault type is selected. After the selection, fault propagation processing for the fault type is performed by the RTP method to search for a fault excitation state. If the fault propagation processing fails, an input sequence created during the unsuccessful process is taken as a test pattern. If it succeeds, state justification processing is performed in the manner described now. First, whether the found fault excitation state S(9) is contained in the states reached by the state transition graph generator is determined. If it is contained therein, the test pattern leading to the fault excitation state and the test pattern generated by the fault propagation processing are connected together to create a test pattern. If such a state is not contained therein, state justification processing is done for one unit period of time by the RTP method. Then, whether a target state S(8) found by the RTP method by going back to the immediately preceding time is one of the states reached by the state transition graph generator is determined. In this way, state is justified while performing a check as to whether the target state undergoing state justification processing by the RTP method is coincident with any one of the states within the state transition graph. For example, Fig. 27 shows a case in which a target state S(7) agrees with any one of the states within the state transition graph.

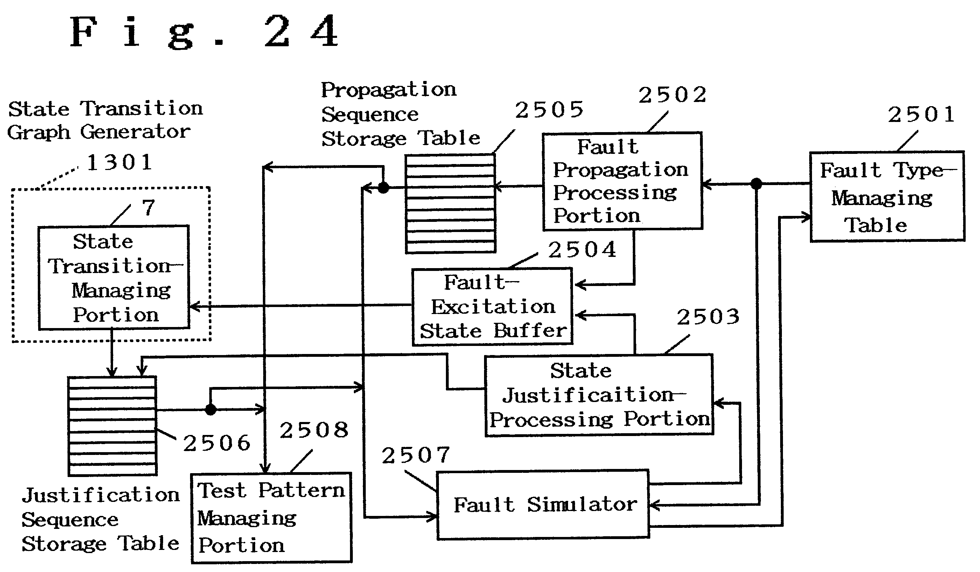

Fig. 24 shows the structure of the second embodiment of the novel test pattern generator. In this figure, a state justification processing portion 2503 is exactly the same as the corresponding component of the test pattern generator using the RTP method as already described in conjunction with the prior art techniques. The second embodiment differs from the first embodiment in that the state justification processing portion 2503 is added as a component and that the fault excitation state buffer 2504 receives inputs from the fault propagation-processing portion 2502 and also from the state justification processing portion 2503.

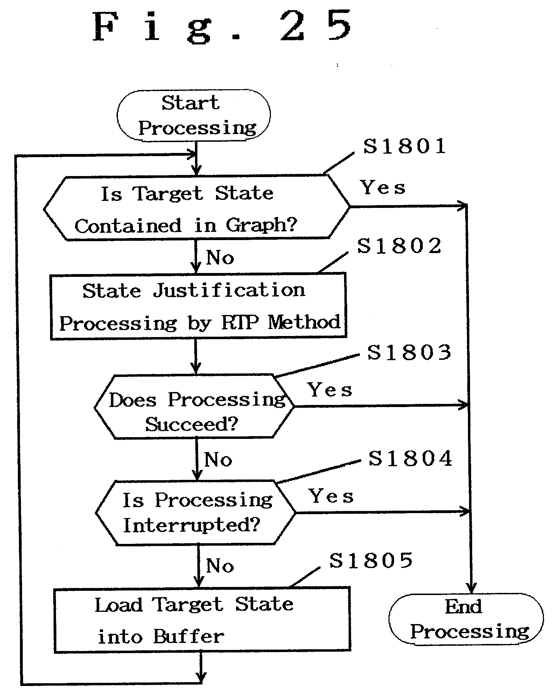

The operation of the second embodiment of the novel test pattern generator is described in detail below with reference to Figs. 21, 24, and 25. The operation of the second embodiment differs from that of the first embodiment only in the state justification processing of step 1406 and fault simulation of step 1408. Consequently, only these two operations are described. Fig. 25 is a flowchart specifically illustrating the state justification processing (step 1406). First, in step 1408, in addition to the operation described in connection with the first embodiment, the state of a fault-free circuit after making a simulation of a fault is supplied to the state justification processing portion.

(step 1801)

The state transition-managing portion 7 determines whether the target state (a fault excitation state in the first operation) loaded in the fault excitation state buffer 2504 is contained in the states reached by the state transition graph. If the target state is contained therein, the managing portion 7 loads a test pattern leading to the coincident target state from an arbitrary initial state into the justification sequence storage table 2506. Thus, the state justification processing is ended.

(step 1802)

The state justification processing portion 2503 performs state justification processing corresponding to one unit period of time by the RTP method. The generated inspection input is delivered to the justification sequence storage table 2506.

(step 1803)

The state justification processing portion 2503 determines whether the justification of state has been successfully performed. If it succeeds, the test pattern which is loaded in the justification sequence storage table 2506 and leading to a fault excitation state from an initial state is a state justification sequence. Thus, the state justification processing is ended. The initial state at this time is the state of the fault-free circuit after driving the fault simulator 2507 in step 1808.

(step 1804)

The state justification processing portion 2503 determines whether the processing for justifying states should be interrupted. This interruption occurs when the situation described in the description of the problems to be solved by the invention (Figs. 6 and 7) occurs.

(step 1805)

The state justification processing portion 2503 loads the target state (such as S(8) in Fig. 27) presently undergoing state justification processing into the fault excitation state buffer 2504. Control then goes back to step 1801.

In step 1404 of Fig. 21, the fault propagation processing portion 2502 may change the method of search, repeat the fault propagation processing, and search for different fault excitation states.

As described above, in the second embodiment of the novel test pattern generator, state justification processing is performed by utilizing the RTP method and the above-described novel state transition graph generator in a complementary manner and, therefore, the performance of the state justification processing is improved. This can improve the fault coverage.

A third embodiment of the novel test pattern generator is described below. This third embodiment utilizes the aforementioned method of creating a state transition graph as processing subsequent to the test pattern generator making use of the RTP method. That is, after the test pattern generator based on the RTP method creates a test pattern once, additional inspection inputs are created for fault types which cannot be detected. This concept of generating inspection inputs is exactly the same as the concept of the first embodiment. The concept is illustrated in Figs. 22 and 23, and is described below.

First, a state transition graph is created, using a fault-free sequential circuit of any one of the above-described embodiments of the state transition graph generator. This corresponds to state justification processing in generating a test pattern. That is, a test pattern leading to a state which can be reached from an unknown initial state is previously created. Then, one undetected fault type is selected. Subsequently, fault propagation processing for the fault type is performed by the RTP method. If the fault propagation processing fails, the generation of an inspection input for that fault type is interrupted. If the processing succeeds, the process goes to state justification processing. More specifically, a check is performed to see if a fault excitation state is contained in the state reached by the state transition graph generator. If it is contained therein, the test pattern leading to the fault excitation state and the test pattern generated by the fault propagation processing are connected together to create a test pattern for the fault type.

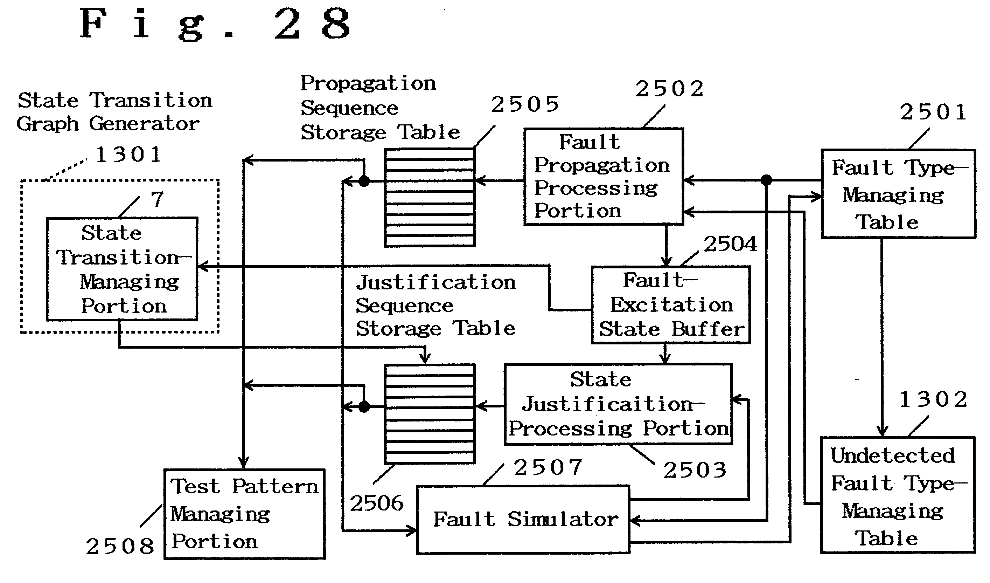

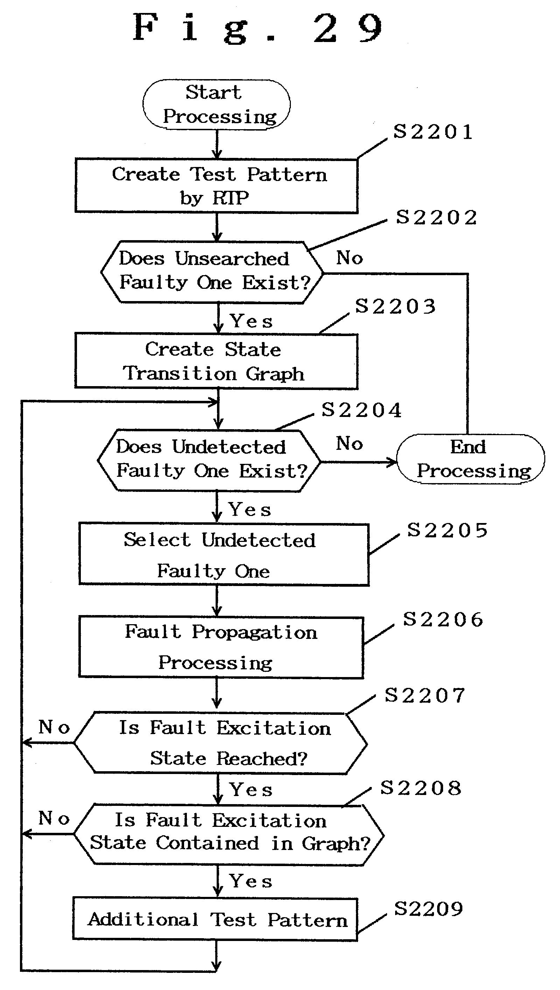

Fig. 28 shows the structure of the third embodiment of the novel test pattern generator. In this figure, an undetected fault type-managing table 1302 manages fault types which remain undetected when test patterns are created by the use of a fault propagation processing portion 2502 and a state justification

24

processing portion 2503. The difference of the third embodiment from the first embodiment of the invention is that the state justification processing portion 2503 and the undetected fault type-managing table 1302 are added as components. Fig. 29 is a flowchart illustrating the operation of the third embodiment of the novel test pattern generator.

The operation of the third embodiment of the novel test pattern generator constructed as described above is described below.

(step 2201)

Test patterns are created, using the fault propagation processing portion 2502 and the state justification processing portion 2503. Detailed operation for the processing is exactly the same as the operation already described in the item of the prior art techniques. As a result, fault types left undetected are stored in the undetected fault type-managing table 1302.

(step 2202)

The undetected fault type-managing table 1302 performs a check to see if undetected fault types are present. If they not present, the processing for generating test patterns is ended.

(step 2203)

The state transition graph generator 1301 creates a state transition graph for a fault-free circuit. The operation for creating a state transition graph is the same as the operation described previously in the embodiments of the novel state transition graph generator.

The following operation is a processing involving loops corresponding in number to the undetected fault types.

(step 2204)

The undetected fault type-managing table 1302 performs a check to see if undetected fault types are present. If they not present, the processing for generating test patterns is ended.

(step 2205)

The undetected fault type-managing table 1302 selects one from among the undetected fault types.

(step 2206)

The fault propagation processing portion 2502 performs fault propagation processing for the selected fault type. The resulting fault propagation sequence is loaded into the propagation sequence storage table 2505.

(step 2207)

The fault propagation processing portion 2502 performs a check to see if the fault propagation processing is successfully performed. If successful, the fault excitation state is loaded into the fault excitation state buffer 2504. If unsuccessful, the propagation sequence storage table 2505 is reset, and control returns to step 2204.

(step 2208)

The state transition-managing portion 7 performs a check to see if the fault excitation state loaded in the fault excitation state buffer 2504 is contained in the states reached by the state transition graph created in step 2203. If it is contained therein, the managing portion 7 loads a test pattern leading from an arbitrary initial state to the coincident fault excitation state into the justification sequence storage table 2506. If it is not contained therein, the table 2505 is reset, and control goes back to step 2204.

25

(step 2209)

Test patterns loaded in the justification sequence storage table 2506 and in the propagation sequence storage table 2505 are loaded into the test pattern-managing portion 2508 in that order. Control returns to step 2204.

Finally, the result of generation of test patterns in the third embodiment of the novel test pattern generator will be described. As a state transition graph generator, the generator described in the third embodiment described above is used. Used sequential circuits are some of the benchmark circuits described in Proc. of Int. Symp. Circuit and Systems (1989), pp. 1929-1934 (ISCAS' 89). Fault coverages are listed in Table 1. For comparison, fault coverages obtained only by the prior art techniques are also listed.

Table 1

| circuit name | fault coverage according to the invention | fault coverage according to prior art techniques |
|---|---|---|
| s298 | 85.71% | 84.42% |
| s344 | 95.91% | 92.42% |
| s382 | 91.23% | 87.97% |
| s444 | 89.03% | 86.29% |
| s1494 | 93.89% | 93.16% |

In the description of the operation of the present embodiment, the fault propagation processing portion 2502 performs fault propagation processing for undetected fault types in step 2206. It is also possible to provide a means for holding information regarding fault propagation processing when test patterns are generated in step 2201 and to omit this processing. Furthermore, in step 2206, the fault propagation processing portion 2502 may also vary the method of search to perform fault propagation processing different from the processing of step 2201, to search for a different fault excitation state.

As described thus far, in the third embodiment of the novel test pattern generator, with respect to fault types whose states were unsuccessfully justified by the RTP method, their states can be justified by the use of the novel state transition graph generator described above. This improves the performance of the state justification processing and enhances the fault coverage.

The various means and simulators used in the present invention may be realized by software used in a computer. Also, they may be realized using dedicated hardware circuits having the same functions.

As can be understood from the description set forth thus far, the present invention defines an evaluation function which can take an optimum evaluated value when a pseudo-primary output value or state is different from the hysteresis observed in the past. Therefore, the problem of finding a state transition graph can be concluded in the problem of maximization of this evaluation function. This evaluation function is based on an amount of information defined in terms of a square matrix having only a dimension of the number of bits of flip-flops, the amount of information being given by Eq. 5. Therefore, almost no storage capacity is needed.

Also, a nonlinear system approximating a sequential circuit is used. This makes the required storage capacity much smaller than for a BDD.

Furthermore, a nonlinear system approximating a sequential system is introduced. An input which maximizes the evaluation function is searched by making use of the partial differential coefficient of the evaluated value with respect to the input value and, therefore, the number of trial searches for inputs is rendered very low.

Moreover, those input bits which by no means affect the pseudo-primary output value are distinguished. If such input bits are present, the space in which inputs are searched is narrowed. This reduces the amount of calculation needed for the search. Hence, very practical advantages can be derived therefrom.

Meanwhile the maximization or minimization operation in the above-mentioned embodiments can be changed to the contrary accoding to various conditions , that is, said operation of the present invention means optimazation.

In the present test pattern generator described above, the performance of the state justification processing can be improved compared with the prior art RTP method. This test pattern generator has an excellent fault coverage.

**Claims**

1. A state transition graph generator comprising:

a digital logical simulator (3) using a sequential circuit having at least one storage element, for calculating a pseudo-primary output value from an input value and a state of the storage element;

an analog logical calculation means (1) for causing logic elements included in the sequential circuit to assume an analog form, calculating analog logic values of signal lines in the sequential circuit according to the input value and the state of the storage element, and updating the state of the storage element by making use of the pseudo-primary output value calculated by the digital logical simulator;

an information amount-calculating means (4) for performing calculations to store the pseudo-primary output value as a hysteresis in an inverse matrix of a covariance matrix, the pseudo-primary output value being delivered from said analog logical calculation means after being calculated by the sequential circuit;

an evaluated value-calculating means (5) for calculating an evaluated value which is optimized as a difference between the pseudo-primary output value output from said analog logical calculation means and the hysteresis of the pseudo-primary output value delivered from said information calculation means increases;

an evaluated value partial differential coefficient-calculating means (6) for calculating a partial differential coefficient of the evaluated value with respect to the input value from the pseudo-primary output value of the sequential circuit delivered from said analog logical calculation means; and

an input-setting means (9) for estimating an input search direction which optimizes the evaluated value from the evaluated value partial differential coefficient delivered from said evaluated value partial differential coefficient-calculating means and for repeatedly searching for an input value that optimizes the evaluated value.

2. A state transition graph generator comprising:

an analog logical calculation means for causing logic elements included in a sequential circuit having at least one storage element to take an analog form and for calculating analog logical values of signal lines in the sequential circuit from an input value and from a base state;

an information amount-calculating means for performing calculations to store a pseudo-primary output value of the sequential circuit as a hysteresis in a covariance matrix, the pseudo-primary output value being delivered from said analog logical calculation means;

an evaluated value-calculating means for calculating an evaluated value which is optimized as a difference between the pseudo-primary output value output from said analog logical calculation means and the hysteresis of the pseudo-primary output value delivered from said information amount-calculating means increases;

an evaluated value partial differential coefficient-calculating means for calculating the evaluated value with respect to the input value from the pseudo-primary output value of the sequential circuit delivered from said analog logical calculation means;

an input-setting means for estimating an input search direction which optimizes the evaluated value from the evaluated value partial differential coefficient delivered from said evaluated value partial differential coefficient-calculating means and for repeatedly searching for an input value that optimizes the evaluated value; and

a state transition-managing means for maintaining a state reached by said input-setting means with a searched input value and an input sequence leading to this state and for outputting a state forming a basis for a search to said analog logical calculation means to search for a next reachable state.

3. A state transition graph generator comprising:

an analog logical calculation means for causing logic elements included in a sequential circuit having at least one storage element to take an analog form and for calculating analog logical values of signal lines in the sequential circuit from an input value and from a base state;

a first information amount-calculating means for performing calculations to store a pseudo-primary output value of the sequential circuit delivered from said analog logical calculation means as a hysteresis in a covariance matrix;

a second information amount-calculating means for performing calculations to divide the pseudo-primary output value of the sequential circuit output from said analog logical calculation means into parts each consisting of several bits and for storing these parts in their respective covariance matrices as a hysteresis;

a first evaluated value-calculating means for calculating an evaluated value which is optimized as a difference between the hysteresis of the pseudo-primary output value output from said first information amount-calculating means and the pseudo-primary output value delivered from said analog logic calculation means increases;

a second evaluated value-calculating means for calculating an evaluated value which is optimized as a difference between the hysteresis of the pseudo-primary output value output from said second information amount-calculating means and the pseudo-primary output value delivered from said analog logic calculation means increases and for calculating as a final evaluated value a linear sum of this evaluated value and an evaluated value calculated by said first evaluated value-calculating means;

an evaluated value partial differential calculation means for calculating a partial differential coefficient of the evaluated value with respect to the input value from the pseudo-primary output value of the sequential circuit delivered from said analog logical calculation means;

an input-setting means for estimating an input search direction which optimizes the evaluated value from the evaluated value partial differential coefficient delivered from said evaluated value partial differential coefficient-calculating means and for repeatedly searching for an input value that optimizes the evaluated value; and

a state transition-managing means for maintaining a state reached by said input-setting means with a searched input value and an input sequence leading to this state and for outputting a state forming a basis for a search to said analog logical calculation means to search for a next reachable state.

4. The state transition graph generator in accordance with claim 1, 2, or 3, wherein

a differentiated value-calculating means for calculating a Jacobian matrix of the pseudo-primary output value with respect to the input value is further comprised , and

the evaluated value partial differential calculation means calculates the partial differential coefficient from the Jacobian matrix and the pseudo-primary output value.

5. The state transition graph generator in accordance with claim 1, 2, or 3 , wherein

the input value has bits , and

said input-setting means has a function of distinguishing those bits which do not affect the pseudo-primary output value.

6. A test pattern generator for a sequential circuit, comprising:

a fault propagation processing means (2502) for generating a test pattern until a fault-free circuit and a faulty circuit output different output values from a fault excitation state of the sequential circuit;

a state-maintaining means (2504) for maintaining the fault excitation state delivered from said fault propagation processing means;

a state transition graph-generating means (1301) for searching for a reachable state from an arbitrary initial state; and

a state transition-managing means (7) for maintaining states searched by said state transition graph-generating means and test patterns leading to the states from an arbitrary initial state, extracting a fault excitation state from said state-maintaining means, determining whether this fault excitation state is present in the searched states, and generating a test pattern leading to this fault excitation state if it is present.

7. A test pattern generator for a sequential circuit, comprising:

a state justification processing means for generating a test pattern until a fault-free circuit and a faulty circuit become different in operation as a fault excitation state from an initial state;

a fault propagation processing means for generating a test pattern until a fault-free circuit and a faulty circuit output different output values from a fault excitation state;

a state-maintaining means for maintaining the fault excitation state generated by said fault propagation processing means and a target state which is generated by said state justification processing means and is presently undergoing state justification processing;

a state transition graph-generating means for searching for a state that can be reached from an arbitrary initial state; and

a state transition-managing means for maintaining states searched by said state transition graph-generating means and test patterns leading to the states from the arbitrary initial state, extracting a fault excitation state or a target state from said state maintaining-means, determining whether this fault excitation state is present in the searched states, and generating a test pattern leading to this fault excitation state if it is present.

8. A test pattern generator for a sequential circuit, comprising:

a state justification processing means for generating a test pattern until a fault-free circuit and a faulty circuit become different in operation as a fault excitation state from an initial state;

a fault propagation processing means for generating a test pattern until a fault-free circuit and a faulty circuit output different output values in response to a fault excitation state;

a state-maintaining means for maintaining the fault excitation state generated by said fault propagation processing means;

a state transition graph-generating means for searching for a state that can be reached from an arbitrary initial state; and

a state transition-managing means for maintaining states searched by said state transition graph-generating means and test patterns leading to the states from an arbitrary initial state, extracting a fault excitation state that is a type of fault which can be detected neither by said state justification processing means nor by said fault propagation processing means from said state-maintaining means, determining whether this fault excitation state is present in the searched states, and generating a test pattern leading to this fault excitation state if it is present.

# F i g . 1 (PRIOR ART)

# F i g . 2 (PRIOR ART)

A
B
C
Z

$$Z=AB+C$$

(Logic Circuit)

A

241 Node

1

0

B

0

C

1

242 Node

0

1

243 Block

0

1

# F i g. 3(PRIOR ART)

Propagation Sequence Storage Table — 2505

Fault Propagation Processing Portion — 2502

Fault Type Managing Table — 2501

Justification Sequence Storage Table

Fault-Excitation State Buffer — 2504

State Justificaition-Processing Portion — 2503

2508

2506

Test Pattern Managing Portion

Fault Simulator — 2507

# Fig. 4 (PRIOR ART)

```
        ┌─────────────┐
        │    Start    │
        │  Processing │
        └──────┬──────┘
               │                              S2601
               ▼
       ╱───────────────╲      No        ┌─────────────┐
      ╱ Does Undetected ╲──────────────▶│     End     │
      ╲ Faulty One Exist?╱              │  Processing │
       ╲───────┬───────╱                └─────────────┘
               │ Yes
               ▼                              S2602
       ┌───────────────┐
       │ Select Undetected │
       │   Faulty One   │
       └───────┬───────┘
               │                              S2603
               ▼
       ┌───────────────┐
       │ Fault Propagation │
       │    Processing  │
       └───────┬───────┘
               │                              S2604
               ▼
       ╱───────────────╲     No
      ╱ Does Fault Propagation╲────────────┐
      ╲ Processing Succeed?   ╱            │
       ╲───────┬───────╱                   │
               │ Yes         S2605         │
               ▼                           │
       ┌───────────────┐                   │
       │ State Justification│              │
       │    Processing  │                  │
       └───────┬───────┘                   │
               │◀──────────────────────────┘
               ▼                              S2606
       ┌───────────────┐
       │   Load Test    │
       │ Pattern into Table │
       └───────┬───────┘
               │                              S2607
               ▼
       ┌───────────────┐
       │ Fault Simulation │
       └───────┬───────┘
               │
               ▼
```

33

# F i g . 5 (PRIOR ART)

Faulty Circuit — Sf(t+2)

Detection of Fault

Sf(t+1)

u(t−1)

u(t+1)

u(t)

S(t)

S(t+1)

S(t+2)

Fault-free Circuit

u(1)

S(2)

Fault-Excitation State

u(2)

S(1)

Fault Propagation Processing

S(0)

u(0)

Initial State

State Justification Processing

EP 0 574 919 A2

# F i g . 6 (PRIOR ART)

# F i g . 7 (PRIOR ART)

# Fig. 8

EP 0 574 919 A2

# Fig. 9

Start Processing

○

| Initialize | S201 |

↓

| Drive Analog Logic Calculator | S202 |

↓

| Drive Differentiated Value-Calculating Portion | S203 |

↓

| Drive Digital Logic Simulator | S204 |

↓

| Calculate Information Matrix | S205 |

↓

| Advance Time | S206 |

↓

| Input Search Processing | S207 |

↓

| Drive Digital Logic Simulator | S208 |

↓

N ⟨ Satisfy End Conditions? ⟩ Y — ○ End    S209

# F i g . 1 0

Start Processing

```
Set Initial Input
Value to u⁰(t)                    S 3 0 1

Set J⁰(t) to 0                    S 3 0 2

Drive Analog Logic
Simulator with u^I(t)            S 3 0 3

Calculate J^I(t)                  S 3 0 4

J^I(t) > J^{I-1}(t)?              S 3 0 5

Calculate Partial
Differential Coef.               S 3 0 6

Take Input Value
u^{I-1}(t) as final
result                           S 3 0 9

Find Next Input
Value u^{I+1}(t)                 S 3 0 7

u^I(t) ≠ u^{I+1}(t)?             S 3 0 8

End
```

# Fig. 11

# Fig. 12

EP 0 574 919 A2

# F i g . 1 3

Start Processing

Initialize System — S601

Base Search Processing — S602

Are End Conditios Met? — S603 — Yes → End Processing

No

Change Base State — S604

Reset Information Amount — S605

# Fig. 14

```
        ┌─────────────┐
        │    Start    │
        │  Processing │
        └──────┬──────┘
               │              S701
        ┌──────▼──────────────┐
        │ Set Initial Input Value │
        └──────┬──────────────┘
               │              S702
        ┌──────▼──────────────┐
        │ Input Search Proccesing │
        └──────┬──────────────┘
               │              S703
          ╱────▼────╲    No
         ⟨ Is New State ⟩──────────┐
         ⟨  Reached?   ⟩           │
          ╲─────────╱             │
               │ Yes              │
     S704      ▼              S705 │
        ┌──────────────┐     ╱────▼────╲      Yes
        │ Store New State│   ⟨ Are End    ⟩───────┐
        │   in Table   │   ⟨ Conditios Met?⟩      │
        └──────┬───────┘    ╲─────────╱          │
               │                  │ No            │
               ◄──────────────────┘              │
               │              S706                │
        ┌──────▼──────────────┐                  │
        │ Store Reached State in │               │
        │  Information Amount  │          ┌──────▼──────┐
        └──────┬──────────────┘          │     End     │
               │              S707        │  Processing │
        ┌──────▼──────────────┐          └─────────────┘
        │ Set Next Input Value │
        │   At Random    │
        └──────┬──────────────┘
               │
               └──────(back to S702)
```

43

# Fig. 15

```
        ┌─────────────┐
        │    Start    │
        │ Processing  │
        └──────┬──────┘
               │              S801
        ┌──────▼──────────┐
        │  Set Initial    │
        │ Evaluated Value │
        └──────┬──────────┘
               │              S802
        ┌──────▼──────────────────┐
        │ Calculate Evaluated Value│
        │   with Modified Input    │
        └──────┬──────────────────┘
               │              S803
         ┌─────▼─────┐    No
        ╱ Has Evaluated ╲──────────┐
        ╲ Value Decreased?╱         │
         └─────┬─────┘              │
            Yes │         S804      │
        ┌──────▼──────────┐         │
        │ Calculate Direction of│   │
        │  Steepest Descent │     │
        └──────┬──────────┘        │
               │         S805      │
        ┌──────▼──────────┐        │
        │ Change Input Value│      │
        │ along Direction of│      │
        │  Steepest Descent │      │
        └──────┬──────────┘        │
               │         S806      │
         ┌─────▼─────┐  No         │
        ╱ Has Input Value╲─────────┤
        ╲ been Changed? ╱          │
         └─────┬─────┘      S807    │
            Yes │      ┌─────────▼──────┐
                │      │Take Unchanged Value│
                │      │  as Final One  │
                │      └────────┬───────┘
                │               │
                │      ┌────────▼───────┐
                │      │ Digital Logic  │
                │      │  Simulation    │
                │ S808 └────────┬───────┘
                │               │
                │        ┌──────▼──────┐
                │        │    End      │
                │        │ Processing  │
                │        └─────────────┘
```

# Fig. 16

Initial State
(Unknown)

Change Base State

First Loop: S(t) ⟹ S(t')

Search for Plural States

Second Loop: S(t) Base State

Search for One State

Third Loop: S(t) Base State

EP 0 574 919 A2

# F i g . 1 7

Input Search Processing

(Third Loop)

|  | Input Value | Direction of Steepest Descent | Evaluated Value |
|---|---|---|---|
| Initial Input Value u0 (k) | 1, −1, 1, −1, 1 | | J0 (k) 12. 4 |
| | | (−, −, −, +, +) | |
| u1 (k) | 1, 1, 1, −1, −1 | | J1 (k) 10. 8 |
| | | (−, +, +, −, +) | |
| u2 (k) | 1, −1, −1, 1, −1 | | J2 (k) 9. 9 |
| | | (−, +, +, −, +) | |
| u3 (k) | 1, −1, −1, 1, −1 | | J3 (k) 9. 9 |

Final
Input Value   u (k) = u2 (k)

Method of Changing

| Input Value | Direction of Steepest Descent | | Input Value |
|---|---|---|---|
| | + | ⟹ | − 1 |
| | − | ⟹ | 1 |

Fig. 18

# F i g .  1 9

y (k)

Bits Indicating
Whole State

| $y_1(k)$ | $y_2(k)$ | $y_3(k)$ | $y_4(k)$ |

2-bit Division

| $y_1(k)$ | $y_2(k)$ |   | $y_3(k)$ | $y_4(k)$ |

$z_1(k)$  $z_2(k)$

48

# Fig. 20

State Transition Graph Generator
1301

Propagation Sequence Storage Table

2502

2501

State Transition-Managing Portion  7

Fault Propagation Processing Portion

Fault Type-Managing Table

2505

Fault-Excitation State Buffer  2504

Justification Sequence Storage Table  2506

Test Pattern Managing Portion  2508

Fault Simulator  2507

EP 0 574 919 A2

# Fig. 21

```
         ┌──────────────┐
         │    Start     │
         │  Processing  │
         └──────────────┘
                │
                ▼                         S1401
    ┌─────────────────────────┐
    │     Generate State      │
    │    Transition Graph     │
    └─────────────────────────┘
                │
                ▼                         S1402
         ╱─────────────────╲      No    ┌──────────────┐
        ╱  Does Unsearched   ╲ ────────▶│     End      │
        ╲  Faulty One Exist? ╱          │  Processing  │
         ╲─────────────────╱            └──────────────┘
                │ Yes
                ▼                         S1403
    ┌─────────────────────────┐
    │     Select Unsearched   │
    │       Faulty One        │
    └─────────────────────────┘
                │
                ▼                         S1404
    ┌─────────────────────────┐
    │     Fault Propagation   │
    │        Processing       │
    └─────────────────────────┘
                │
                ▼                         S1405
         ╱──────────────────────╲   No
        ╱  Does Fault Propagation ╲ ──────┐
        ╲  Processing Succeed?    ╱       │
         ╲──────────────────────╱         │
                │ Yes        S1406         │
                ▼                          │
    ┌─────────────────────────┐           │
    │    State Justification  │           │
    │        Processing       │           │
    └─────────────────────────┘           │
                │◀─────────────────────────┘
                ▼                         S1407
    ┌─────────────────────────┐
    │     Load Test Pattern   │
    │        into Table       │
    └─────────────────────────┘
                │
                ▼                         S1408
    ┌─────────────────────────┐
    │     Fault Simulation    │
    └─────────────────────────┘
                │
                ▼
```

# Fig. 22

State Justification Processing based on Creation of State Transition Graph

Fault Propagation Processing by RTP Method

Test Pattern

u (0)→u (1)→u (2)→u (3)→u (4)

→u (5)→u (6)→u (7)→u (8)

EP 0 574 919 A2

# F i g . 2 3

State Justification Processing based on
Creation of State Transition Graph

Fault Propagation Processing
by RTP Method

S (4)

S (1)

S (5)

Sf(9) Faulty
Circuit

Sf(8)

Coincident

u (8)

S (9) Fault-free
Circuit

u (7)

S (0) —u (0)→ S (2) —u (2)→ S (6) —u (6)→ S (7) ⟷ S (7) S (8)

Initial State
(Unknown)

Fault-Excitation
State

S (3)

RTP Method

Test Pattern
u (0)→u (2)→u (6)→u (7)→u (8)

EP 0 574 919 A2

# Fig. 24

State Transition Graph Generator 1301

State Transition Managing Portion 7

Propagation Sequence Storage Table 2505

Fault Propagation Processing Portion 2502

Fault Type Managing Table 2501

Fault Excitation State Buffer 2504

State Justificaition Processing Portion 2503

Justification Sequence Storage Table 2506

Test Pattern Managing Portion 2508

Fault Simulator 2507

EP 0 574 919 A2

# F i g . 2 5

```
                    ┌─────────────┐
                    │   Start     │
                    │ Processing  │
                    └─────────────┘
                           │           S1801
                           ▼
              ╱─────────────────────────╲      Yes
             ╱    Is Target State         ╲─────────────►
             ╲  Contained in Graph?       ╱
              ╲─────────────────────────╱
                           │ No          S1802
                           ▼
              ┌─────────────────────────┐
              │  State Justification     │
              │ Processing by RTP Method │
              └─────────────────────────┘
                           │             S1803
                           ▼
                  ╱─────────────╲        Yes
                 ╱ Does Processing╲──────────────►
                 ╲   Succeed?     ╱
                  ╲─────────────╱
                           │ No          S1804
                           ▼
                  ╱─────────────╲        Yes
                 ╱ Is Processing  ╲──────────────►
                 ╲  Interrupted?  ╱
                  ╲─────────────╱
                           │ No          S1805
                           ▼
              ┌─────────────────────────┐          ┌─────────────┐
              │   Load Target State      │          │    End      │
              │    into Buffer           │          │ Processing  │
              └─────────────────────────┘          └─────────────┘
```

54

# Fig. 26

**State Justification Processing based on Creation of State Transition Graph**

Coincident

Initial State (Unknown)

S(0) → u(0) → S(1) → u(1) → S(2) → u(2) → S(3) → u(3) → S(4)

S(1) → u(5) → S(6) → u(6) → S(7)

u(4)

**Test Pattern**

u(0)→u(1)→u(2)→u(3)→u(4)→u(5)
→u(6)→u(7)→u(8 →u(9)→u(10)

**State Justification Processing by RTP Method**

S(7) Target State

↑u(7)

S(8) Target State

RTP Method

**Fault Propagation Processing by RTP Method**

u(8)

Sf(10) → Sf(11) Faulty Circuit

u(10)

S(9) → u(9) → S(10) → S(11) Fault-free Circuit

Fault-Excitation State

RTP Method

EP 0 574 919 A2

# F i g . 2 7

**State Justification Processing based on Creation of State Transition Graph**

S (4)

S (1)

S (5)

Initial State (Unknown)

u (0)

S (0) → S (2)

S (6)

u (2)

S (3)

S (7)

Coincident

Test Pattern
u (0)→u (2)→u (7)→u (8 →u (9)→u (10)

**Fault Propagation Processing by RTP Method**

Sf(11) Faulty Circuit

Sf(10)

u (10)

u (9)

S (11) Fault-free Circuit

S (9) → S (10)

Fault-Excitation State

u (8)

RTP Method

**State Justification Processing by RTP Method**

S (8) Target State

u (7)

S (7) Target State

# Fig. 28

State Transition
Graph Generator

Propagation
Sequence
Storage Table

2505

2502

2501

1301

7

State
Transition—
Managing
Portion

Fault
Propagation
Processing
Portion

Fault Type—
Managing
Table

2504

Justification
Sequence
Storage Table

Fault—
Excitation
State Buffer

1302

State
Justificaition—
Processing Portion

2506

2507    2503

Undetected
Fault Type—
Managing
Table

Test Pattern
Managing
Portion

Fault Simulator

2508

EP 0 574 919 A2

# Fig. 29

```
        ┌──────────────┐
        │    Start     │
        │  Processing  │
        └──────────────┘
               │
               ▼                          S2201
        ┌──────────────────┐
        │ Create Test Pattern │
        │      by RTP       │
        └──────────────────┘
               │
               ▼                          S2202
        ┌────────────────────┐    No
        │ Does Unsearched    │─────────────┐
        │ Faulty One Exist?  │             │
        └────────────────────┘             │
               │ Yes        S2203          │
               ▼                           │
        ┌──────────────────┐               │
        │   Create State   │               │
        │ Transition Graph │               │
        └──────────────────┘               │
               │                           │
               ▼            S2204          │
        ┌────────────────────┐    No    ┌──────────┐
   ┌──►│ Does Undetected    │────────►│   End    │
   │    │ Faulty One Exist?  │          │Processing│
   │    └────────────────────┘          └──────────┘
   │           │ Yes
   │           ▼                          S2205
   │    ┌──────────────────┐
   │    │ Select Undetected│
   │    │   Faulty One     │
   │    └──────────────────┘
   │           │
   │           ▼                          S2206
   │    ┌──────────────────┐
   │    │ Fault Propagation│
   │    │    Processing    │
   │    └──────────────────┘
   │           │
   │           ▼                          S2207
   │ No ┌────────────────────┐
   ├───┤ Is Fault Excitation │
   │    │  State Reached?    │
   │    └────────────────────┘
   │           │ Yes           S2208
   │           ▼
   │ No ┌────────────────────────┐
   ├───┤ Is Fault Excitation     │
   │    │ State Contained in Graph?│
   │    └────────────────────────┘
   │           │ Yes
   │           ▼
   │    ┌──────────────────┐         S2209
   │    │ Additional Test Pattern │
   │    └──────────────────┘
   │           │
   └───────────┘
```

58